# EUROPEAN PATENT APPLICATION

(11) **EP 4 439 977 A1**
(43) Date of publication of application: **02.10.2024**
(21) Application number: 24166573.6
(22) Date of filing: 26.03.2024
(51) Int. Cl.: H03F 1/02, H03F 3/19, H03F 3/24

(54) **ENVELOPE TRACKING MODULATOR AND WIRELESS COMMUNICATION SYSTEM**

(30) Priority: 31.03.2023 CN 202310362053
(71) Applicant: Huawei Technologies Co., Ltd., Shenzhen, Guangdong 518129 (CN)
(72) Inventor: ZHOU, Wei, Shenzhen, 518129 (CN); QIAN, Yao, Shenzhen, 518129 (CN); LI, Weinan, Shenzhen, 518129 (CN)
(74) Representative: Gill Jennings & Every LLP

(57) **Abstract**

Embodiments of this application provide an envelope tracking modulator, comprising: a linear amplification circuit, a coupling capacitor, a buck circuit, a circuit sensor, and an offset current generation circuit. An output end of the linear amplification circuit is coupled to a first end of the coupling capacitor, and a second end of the coupling capacitor is coupled to a power supply node. The offset current generation circuit is coupled to the first end and the second end of the coupling capacitor, and the offset current generation circuit is further coupled to a control end of the buck circuit. An input end of the circuit sensor is coupled to a line between the output end of the linear amplification circuit and the first end of the coupling capacitor, and an output end of the circuit sensor is coupled to the control end of the buck circuit.

## Description

### TECHNICAL FIELD

This application relates to the field of integrated circuit technologies, and in particular, to an envelope tracking modulator and a wireless communication system.

### BACKGROUND

An electronic device usually has a wireless communication function. In a process in which the electronic device provides a wireless communication service for a user, it is a common behavior for the electronic device to process a radio frequency (RF) signal. For example, before the electronic device sends the radio frequency signal, output power of the radio frequency signal needs to be increased by using a power amplifier (PA).

Specifically, the power amplifier increases the output power of the radio frequency signal based on a power supply voltage output by an envelope tracking modulator. The envelope tracking modulator may dynamically adjust, based on envelope amplitude information of the radio frequency signal, a value of the power supply voltage output to the power amplifier, to improve operation efficiency of the power amplifier and reduce energy consumption. However, in some scenarios, envelope tracking efficiency of the envelope tracking modulator is low, and the envelope tracking modulator cannot adjust, in a timely manner based on the envelope amplitude information of the radio frequency signal, the value of the power supply voltage output to the power amplifier. Consequently, the operation efficiency of the power amplifier is reduced.

### SUMMARY

Embodiments of this application provide an envelope tracking modulator and a wireless communication system. Envelope tracking efficiency of the envelope tracking modulator is high. When the envelope tracking modulator provides a power supply voltage for a power amplifier, operation efficiency of the power amplifier can be improved.

According to a first aspect, an envelope tracking modulator is provided. The envelope tracking modulator includes a linear amplification circuit, a coupling capacitor, a buck circuit, a circuit sensor, and an offset current generation circuit. An output end of the linear amplification circuit is coupled to a first end of the coupling capacitor, and a second end of the coupling capacitor is coupled to a power supply node. The offset current generation circuit is coupled to the first end and the second end of the coupling capacitor, and the offset current generation circuit is further coupled to a control end of the buck circuit. An input end of the circuit sensor is coupled to a line between the output end of the linear amplification circuit and the first end of the coupling capacitor, and an output end of the circuit sensor is coupled to the control end of the buck circuit. An output end of the buck circuit is coupled to the power supply node. The offset current generation circuit is configured to generate an offset current based on an amplified voltage output by the linear amplification circuit and a power supply voltage output by the power supply node. The buck circuit is configured to generate a first output voltage based on a sum of the offset current and an induced current output by the circuit sensor. When a difference between the power supply voltage and the amplified voltage is less than a reference voltage, the sum of the offset current and the induced current is greater than the induced current; or when a difference between the power supply voltage and the amplified voltage is greater than a reference voltage, the sum of the offset current and the induced current is less than the induced current. In the envelope tracking modulator, when an amplitude of an envelope signal increases, the linear amplification circuit outputs a current, the amplified voltage output by the linear amplification circuit continuously increases, and the difference between the power supply voltage and the amplified voltage continuously decreases. When the difference between the power supply voltage and the amplified voltage is less than the reference voltage, if no offset current generation circuit exists, the induced current is transmitted to the control end of the buck circuit. The buck circuit generates the first output voltage based on the induced current, and a value of the induced current needs to be greater than a first value. In this case, the first output voltage generated by the buck circuit based on the induced current may be a high voltage. The power supply voltage increases only when the first output voltage is the high voltage. Finally, the difference between the power supply voltage and the amplified voltage remains unchanged, and the linear amplification circuit no longer outputs a current. When the offset current generation circuit exists, when a value of the induced current is greater than a first value minus the offset current, the sum of the offset current and the induced current output by the circuit sensor may be greater than the first value. In this case, the first output voltage generated by the buck circuit based on the sum of the offset current and the induced current output by the circuit sensor is a high voltage. The power supply voltage increases when the first output voltage is the high voltage. Finally, the difference between the power supply voltage and the amplified voltage remains unchanged, and the linear amplification circuit no longer outputs a current. It can be learned that, the existence of the offset current generation circuit may enable the first output voltage generated by the buck circuit to become the high voltage as soon as possible, so that the difference between the power supply voltage and the amplified voltage remains unchanged as soon as possible, to improve envelope tracking efficiency of the envelope tracking modulator. When an amplitude of an envelope signal decreases, the linear amplification circuit absorbs a current, the amplified voltage output by the linear amplification circuit continuously decreases, and the difference between the power supply voltage and the amplified voltage continuously increases. When the difference between the power supply voltage and the amplified voltage is greater than the reference voltage, if no offset current generation circuit exists, the induced current is transmitted to the control end of the buck circuit. The buck circuit generates the second output voltage based on the induced current, and a value of the induced current needs to be less than a second value. In this case, the first output voltage generated by the buck circuit based on the induced current may be a low voltage. The power supply voltage decreases only when the first output voltage is the low voltage. Finally, the difference between the power supply voltage and the amplified voltage remains unchanged, and the linear amplification circuit no longer absorbs a current. When the offset current generation circuit exists, when a value of the induced current is less than a first value minus a current value of the offset current, the sum of the offset current and the induced current output by the circuit sensor may be less than the first value. In this case, the first output voltage generated by the buck circuit based on the sum of the offset current and the induced current output by the circuit sensor is a low voltage. The power supply voltage decreases when the first output voltage is the low voltage. Finally, the difference between the power supply voltage and the amplified voltage remains unchanged, and the linear amplification circuit no longer absorbs a current. It can be learned that, the existence of the offset current generation circuit may enable the first output voltage generated by the buck circuit to become the low voltage as soon as possible, so that the difference between the power supply voltage and the amplified voltage remains unchanged as soon as possible, to improve envelope tracking efficiency of the envelope tracking modulator.

Optionally, a first input end of the offset current generation circuit is coupled to the first end of the coupling capacitor, a second input end of the offset current generation circuit is coupled to the second end of the coupling capacitor, and an output end of the offset current generation circuit is coupled to the control end of the buck circuit. The offset current generation circuit includes a voltage detector and an offset current generator. A positive input end of the voltage detector is coupled to the first input end of the offset current generation circuit, a negative input end of the voltage detector is coupled to the second input end of the offset current generation circuit, an output end of the voltage detector is coupled to an input end of the offset current generator, and an output end of the offset current generator is coupled to the output end of the offset current generation circuit. The voltage detector is configured to determine a result of comparing the difference between the power supply voltage and the amplified voltage with the reference voltage, and generate an offset control voltage based on the comparison result. The offset current generator is configured to generate the offset current based on the offset control voltage.

Optionally, the offset current generator includes a first current source, a first switch, a second switch, and a second current source. An input end of the first current source is coupled to the power supply voltage, an output end of the first current source is coupled to a first end of the first switch, and a second end of the first switch is coupled to the output end of the offset current generator. The second end of the first switch is further coupled to a first end of the second switch, a second end of the second switch is coupled to an input end of the second current source, and an output end of the second current source is coupled to the ground. A control end of the first switch is coupled to the input end of the offset current generator, and a control end of the second switch is coupled to the input end of the offset current generator.

Optionally, when the difference between the power supply voltage and the amplified voltage is less than the reference voltage, the offset control voltage is at a first level, the first switch connects the first current source and the output end of the offset current generator, the second switch disconnects the second current source from the output end of the offset current generator, and the first current source outputs the offset current; or when the difference between the power supply voltage and the amplified voltage is greater than the reference voltage, the offset control voltage is at a second level, the first switch disconnects the first current source from the output end of the offset current generator, the second switch connects the second current source and the output end of the offset current generator, and the second current source outputs the offset current. In this optional manner, when the difference between the power supply voltage and the amplified voltage is less than the reference voltage, the offset control voltage generated by a voltage detector based on the determined result of comparing the difference between the power supply voltage and the amplified voltage with the reference voltage is specifically at the first level. The offset control voltage received by the control end of the first switch is at the first level, the first switch is turned on, the first switch connects the first current source and the output end of the offset current generator, the offset control voltage received by the control end of the second switch is at the first level, the second switch is turned off, the second switch disconnects the second current source from the output end of the offset current generator, and the first current source outputs the offset current, so that the control current is greater than the induced current. When the difference between the power supply voltage and the amplified voltage is greater than the reference voltage, the offset control voltage generated by a voltage detector based on the determined result of comparing the difference between the power supply voltage and the amplified voltage with the reference voltage is specifically at the second level. The offset control voltage received by the control end of the first switch is at the second level, the first switch is turned off, the first switch disconnects the first current source from the output end of the offset current generator, the offset control voltage received by the control end of the second switch is at the second level, the second switch is turned on, the second switch connects the second current source and the output end of the offset current generator, and the second current source outputs the offset current, so that the control current is less than the induced current.

Optionally, the buck circuit includes a driver, a third switch, a fourth switch, and an inductor. An input end of the driver is coupled to the control end of the buck circuit, a first output end of the driver is coupled to a control end of the third switch, a second output end of the driver is coupled to a control end of the fourth switch, a first end of the third switch is coupled to a battery voltage, a second end of the third switch is coupled to a first end of the fourth switch, a second end of the fourth switch is coupled to the ground, and the second end of the third switch is further coupled to the output end of the buck circuit through the inductor.

Optionally, the envelope tracking modulator further includes a current adder. The offset current generation circuit is coupled to the control end of the buck circuit through the current adder, and the output end of the circuit sensor is coupled to the control end of the buck circuit through the current adder.

Optionally, the current adder is configured to generate a control current based on the induced current and the offset current, and output the control current.

Optionally, the envelope tracking modulator further includes a hysteresis comparator disposed between the current adder and the buck circuit, and a current-voltage conversion circuit disposed between the current adder and the hysteresis comparator.

Optionally, the current-voltage conversion circuit is configured to generate a comparison control voltage based on the control current output by the current adder. The hysteresis comparator is configured to generate a buck control voltage based on the comparison control voltage. The buck circuit is specifically configured to generate a second output voltage based on the buck control voltage.

Optionally, the linear amplification circuit further includes a mirror output end. The envelope tracking modulator further includes an operational amplifier. A positive input end of the operational amplifier is coupled to the output end of the linear amplification circuit, a negative input end of the operational amplifier is coupled to the mirror output end of the linear amplification circuit, and an output end of the operational amplifier is coupled to an output end of the current-voltage conversion circuit. In this optional manner, when the amplitude of the envelope signal increases, the linear amplification circuit outputs a current, a voltage output by the mirror output end of the linear amplification circuit is greater than a voltage output by the output end of the linear amplification circuit, and the output end of the operational amplifier outputs a low voltage, to form a transmission loop of the control current. When the amplitude of the envelope signal increases, the linear amplification circuit absorbs a current, a voltage output by the mirror output end of the linear amplification circuit is less than a voltage output by the output end of the linear amplification circuit, and the output end of the operational amplifier outputs a high voltage, to form a transmission loop of the control current.

Optionally, the current-voltage conversion circuit includes a resistor, a first end of the resistor is coupled to an input end of the current-voltage conversion circuit, and a second end of the resistor is coupled to the output end of the current-voltage conversion circuit. A positive input end of the hysteresis comparator is coupled to the output end of the current-voltage conversion circuit, and a negative input end of the hysteresis comparator is coupled to the input end of the current-voltage conversion circuit.

Optionally, the linear amplification circuit is configured to amplify an envelope signal received by the envelope tracking modulator, to generate the amplified voltage. The coupling capacitor is configured to: filter out a low-frequency component and a direct current component in the amplified voltage, generate a second output voltage, and transmit the second output voltage to the power supply node. The circuit sensor is configured to detect the amplified voltage to generate and output the induced current. The power supply node is configured to output the power supply voltage based on the first output voltage and the second output voltage.

According to a second aspect, a wireless communication system is provided. The wireless communication system includes a processing circuit and a power supply circuit. The power supply circuit includes one or more envelope tracking modulators according to the first aspect. The processing circuit is configured to generate a radio frequency signal and an envelope signal of the radio frequency signal based on to-be-sent data. The envelope tracking modulator is configured to generate a power supply voltage of a power amplifier based on the envelope signal.

Optionally, the wireless communication system further includes a power amplifier. The power amplifier is configured to amplify output power of the radio frequency signal based on the power supply voltage.

For technical effects achieved by any possible implementation of the second aspect, refer to the technical effects achieved by the implementations of the first aspect. Details are not described herein again.

### BRIEF DESCRIPTION OF DRAWINGS

FIG. 1 is a top view of an electronic device according to an embodiment of this application;
FIG. 2 is a bottom view of an electronic device according to an embodiment of this application;
FIG. 3A and FIG. 3B are a schematic diagram of an internal structure of an electronic device with a rear cover opened according to an embodiment of this application;
FIG. 4 is a schematic diagram of a structure of a wireless communication system according to an embodiment of this application;
FIG. 5 is a waveform diagram of a first amplified output signal and an envelope signal in a wireless communication system according to an embodiment of this application;
FIG. 6 is a schematic diagram of a structure of an envelope tracking modulator according to an embodiment of this application;
FIG. 7 is a current change curve diagram of an envelope tracking modulator according to an embodiment of this application;
FIG. 8 is a schematic diagram of a structure of an envelope tracking modulator according to another embodiment of this application;
FIG. 9 is a current change curve diagram of an envelope tracking modulator according to another embodiment of this application;
FIG. 10 is a schematic diagram of a structure of an envelope tracking modulator according to still another embodiment of this application;
FIG. 11 is a schematic diagram of a structure of an offset current generation circuit in an envelope tracking modulator according to still another embodiment of this application;
FIG. 12 is a schematic diagram of a structure of a buck circuit in an envelope tracking modulator according to still another embodiment of this application;
FIG. 13 is a schematic diagram of a structure of an envelope tracking modulator according to yet another embodiment of this application;
FIG. 14 is a schematic diagram of a structure of an envelope tracking modulator according to another embodiment of this application;
FIG. 15 is a schematic diagram of a structure of an envelope tracking modulator according to still another embodiment of this application; and
FIG. 16 is a current change curve diagram of an envelope tracking modulator according to still another embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Unless otherwise defined, all technical terms used herein have a same meaning as those commonly known to a person of ordinary skill in the art. In embodiments of this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" usually indicates an "or" relationship between the associated objects. "At least one of the following items (pieces)" or a similar expression thereof refers to any combination of these items, including any combination of singular items (pieces) or plural items (pieces). For example, at least one item (piece) of a, b, or c may represent: a, b, c, a and b, a and c, b and c, or a, b, and c, where a, b, and c may be singular or plural. In addition, in embodiments of this application, terms such as "first" and "second" do not limit a quantity or an order.

In addition, in embodiments of this application, position terms such as "top" and "bottom" are defined relative to positions of components in the accompanying drawings. It should be understood that these position terms are relative concepts used for relative description and clarification, and may correspondingly change with the positions of the components in the accompanying drawings.

In embodiments of this application, the term such as "example" or "for example" represent giving an example, an illustration, or a description. Any embodiment or design scheme described as an "example" or with "for example" in embodiments of this application should not be explained as being more preferred or having more advantages than another embodiment or design scheme. Exactly, use of the term such as "example" or "for example" is intended to present a relative concept in a specific manner.

In embodiments of this application, unless otherwise clearly specified and limited, the term "coupling" may be a manner of implementing an electrical connection for signal transmission, and the term "coupling" may be a direct electrical connection, or may be an indirect electrical connection through an intermediate medium.

A linear amplification circuit/linear amplifier (LA) is also referred to as a linear power amplifier. The linear amplification circuit LA is an amplifier with an amplitude of an output signal being in direct proportion to an amplitude of an input signal.

In embodiments of this application, a switch may be implemented through a transistor. For example, when the transistor is cut off, it indicates that the switch is turned off, and a current cannot flow through two ends of the switch; or when the transistor is conducted, it indicates that the switch is turned on, and a current can flow through two ends of the switch. The transistor may be a metal-oxide-semiconductor field effect transistor (MOSFET), and the transistor is classified into two types: an N (negative)-type transistor and a P (positive)-type transistor. The transistor includes a source, a drain, and a gate. Turn-on or turn-off of the transistor may be controlled by controlling a level of a voltage input to the gate of the transistor. When the transistor is conducted, the source and the drain are connected; or when the transistor is cut off, the source and the drain are not connected. In embodiments of this application, the gate of the transistor is also referred to as a control end, the source is referred to as a first end, and the drain is referred to as a second end; or the gate is referred to as a control end, the drain is referred to as a first end, and the source is referred to as a second end. In addition, the N-type transistor is conducted when the level of the control end is a high level, and the first end and the second end are connected; and the N-type transistor is cut off when the level of the control end is a low level, and the first end and the second end are not connected. The P-type transistor is conducted when the level of the control end is a low level, and the first end and the second end are connected; and the P-type transistor is cut off when the level of the control end is a high level, and the first end and the second end are not connected.

Embodiments of this application provide a wireless communication system. The wireless communication system may be used in electronic devices such as a mobile phone, a tablet computer, a personal computer (PC), a personal digital assistant (PDA), a smartwatch, a netbook, a wearable electronic device, an augmented reality (AR) device, a virtual reality (VR) device, a vehicle-mounted device, an intelligent vehicle, a smart speaker, a robot, and smart glasses.

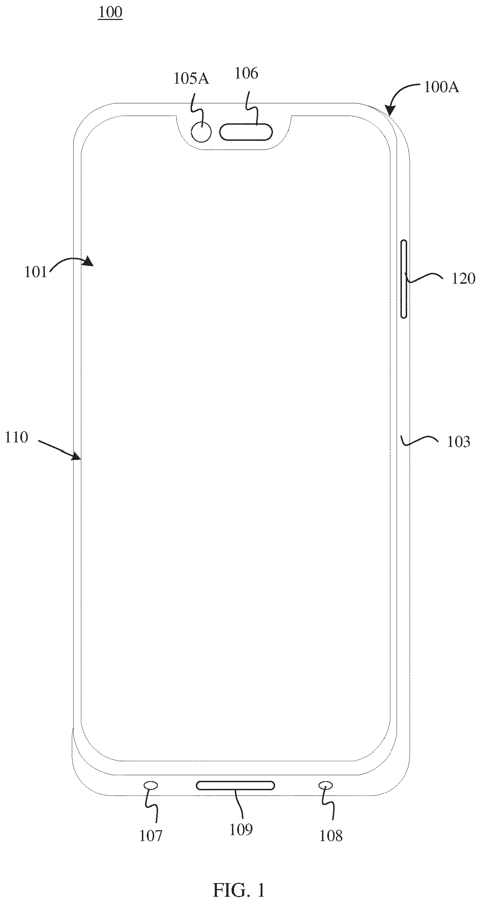

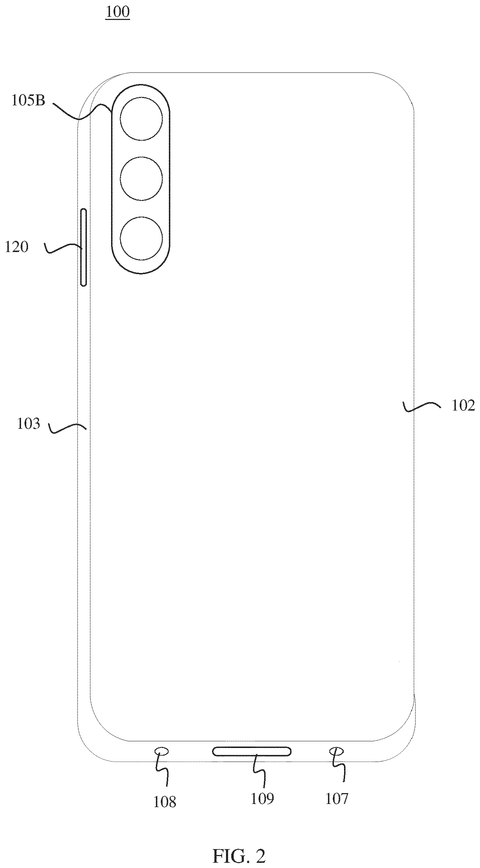

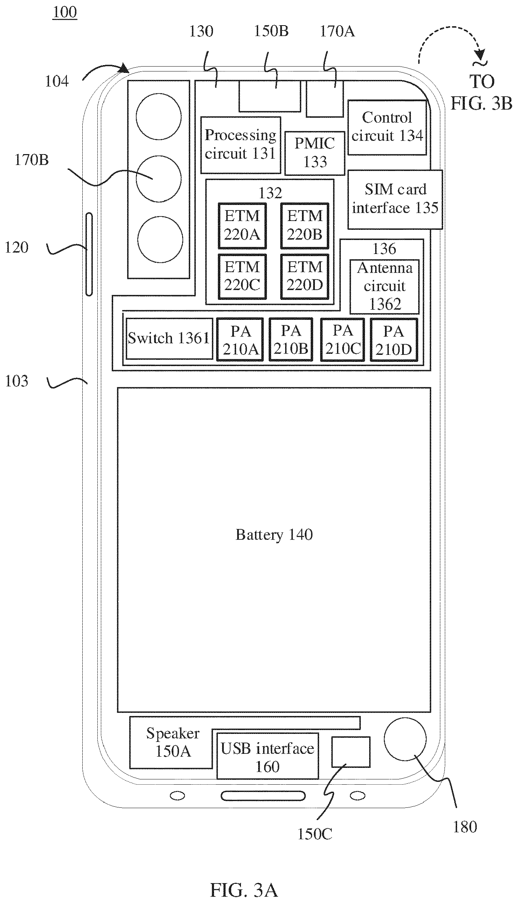

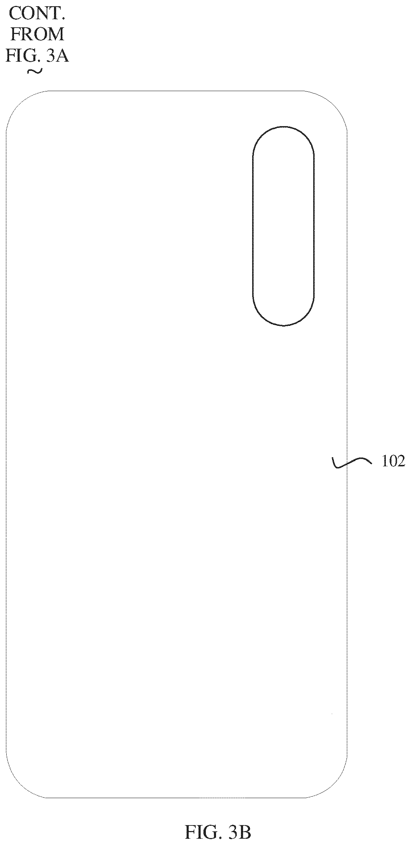

FIG. 1 to FIG. 3A and FIG. 3B are schematic diagrams of a structure of an electronic device 100 according to an embodiment of this application. FIG. 1 is a top view of the electronic device 100 according to this embodiment of this application. FIG. 2 is a bottom view of the electronic device 100 according to this embodiment of this application. FIG. 3A and FIG. 3B are a schematic diagram of an internal structure of the electronic device 100 with a rear cover opened according to this embodiment of this application. FIG. 3A and FIG. 3B show a specific configuration of various internal components of the electronic device 100. A dashed arrow in FIG. 3A and FIG. 3B indicates a direction in which the rear cover is opened. Structures of the electronic device 100 shown in FIG. 1 to FIG. 3A and FIG. 3B do not constitute a specific limitation on the electronic device 100 in this embodiment of this application. In some possible implementations, compared with FIG. 1 to FIG. 3A and FIG. 3B, for example, the electronic device 100 may further include more or fewer components, or some components may be combined, or some components may be divided, or different component arrangements may be used. This is not specifically limited in this embodiment of this application.

As shown in FIG. 1 and FIG. 2, the electronic device 100 may include a housing 100A. The housing 100A may include a front cover 101, a rear cover 102, and a frame 103. The front cover 101 and the rear cover 102 are disposed opposite to each other. The frame 103 surrounds the front cover 101 and the rear cover 102, and couples the front cover 101 to the rear cover 102.

The front cover 101 may be a glass cover, and a display 110 is disposed below the front cover 101. A structure corresponding to an input/output component may be disposed around a periphery of the housing 100A. For example, a hole 105A corresponding to a front-facing camera and/or a hole 106 corresponding to a receiver are/is provided on the top of the front cover 101. A button 120 may be further disposed on one side of the frame 103. Ahole 107 corresponding to a microphone, a hole 108 corresponding to a speaker, and a hole 109 corresponding to a USB interface are provided on the bottom of the frame 103. A hole 105B corresponding to a rear-facing camera may be further provided on the top of the rear cover 102. Certainly, there may be another structure around the housing 100A. This is not specifically limited in this embodiment of this application.

Further, a cavity may be formed inside the housing 100A, and internal components may be accommodated in the cavity. For example, as shown in FIG. 3A and FIG. 3B, the internal components may be accommodated in a cavity 104. During actual application, the internal components may include components such as a printed circuit board (PCB) 130, a battery 140 configured to supply power to the internal components, a speaker 150A configured to convert an audio electrical signal into a sound signal, a receiver 150B configured to convert an audio electrical signal into a sound signal, a microphone 150C configured to convert a sound signal into an audio electrical signal, a USB interface 160, a camera 170A, a camera 170B, and a motor 180 configured to generate a vibration prompt. A processing circuit 131, a power supply circuit 132, a power management integrated circuit (PMIC) 133, a control circuit 134, a SIM card interface 135, a front-end (FEM) circuit 136, and the like may be disposed on the printed circuit board 130. The FEM circuit 136 may include at least one power amplifier (PA), a switch 1361, an antenna circuit 1362, and the like. The power supply circuit 132 may include at least one envelope tracking modulator (ETM). The PMIC 133 provides a battery voltage for the at least one envelope tracking modulator. An output end of the at least one envelope tracking modulator is coupled to a power supply end of the at least one power amplifier. The at least one envelope tracking modulator is configured to supply power to the at least one power amplifier, and one envelope tracking modulator is configured for one power amplifier.

For example, a filter, a low noise amplifier, an audio codec, an internal memory, a sensor, an inductor, and a capacitor may be further disposed on the PCB 130. Herein, to clearly show embodiments of this application, the filter, the low noise amplifier, the audio codec, the internal memory, the sensor, the inductor, and the capacitor are not shown in FIG. 3A and FIG. 3B. Further, because the components on the PCB 130 are arranged closely, to place all the components in limited space, a manner in which the components are arranged on the PCB 130 is not specifically limited in this embodiment of this application. For example, the internal components may be disposed on a surface (for example, a surface facing the rear cover 102) of the PCB 130; or the internal components may be disposed on two surfaces (for example, a surface facing the rear cover 102 and a surface facing the front cover 101) of the PCB 130. This is not specifically limited in this embodiment of this application.

For example, because functions of the electronic device 100 are increasingly complete, a quantity of internal components of the electronic device 100 also increases. In this case, the cavity 104 may further include a sensor, for example, a pressure sensor, a gyroscope sensor, a barometric pressure sensor, a magnetic sensor, an acceleration sensor, a distance sensor, an optical proximity sensor, a fingerprint sensor, a temperature sensor, a touch sensor, an ambient light sensor, and a bone conduction sensor.

For example, as shown in FIG. 3A and FIG. 3B, the at least one power amplifier may include: a power amplifier PA210A, a power amplifier PA210B, a power amplifier PA210C, and a power amplifier PA210D. Different power amplifiers may support a same frequency band or different frequency bands, and are configured to amplify radio frequency (RF) signals in a same frequency band or different frequency bands or in a same bandwidth range or different bandwidth ranges. It is assumed that the power amplifier PA 210A may be configured to amplify a radio frequency signal in a bandwidth range (wideband) A, the power amplifier PA 210B may be configured to amplify a radio frequency signal in a bandwidth range B, the power amplifier PA 210C may be configured to amplify a radio frequency signal in a bandwidth range C, and the power amplifier PA 210D may be configured to amplify a radio frequency signal in a bandwidth range D, where one or more of A, B, C, and D may be the same or different from each other. Correspondingly, the at least one envelope tracking modulator may include: an envelope tracking modulator ETM 220A, an envelope tracking modulator ETM 220B, an envelope tracking modulator ETM 220C, and an envelope tracking modulator ETM 220D. Different envelope tracking modulators may support a same bandwidth range or different bandwidth ranges. The envelope tracking modulator ETM 220A may supply power to the power amplifier PA210A, the envelope tracking modulator ETM 220B may supply power to the power amplifier PA210B, the envelope tracking modulator ETM 220C may supply power to the power amplifier PA 210C, and the envelope tracking modulator ETM 220D may supply power to the power amplifier PA 210D.

For example, the processing circuit 131 shown in FIG. 3A and FIG. 3B may include at least one baseband circuit and at least one radio frequency (RF) circuit. One baseband circuit may correspond to one radio frequency circuit. The baseband circuit and the radio frequency circuit corresponding to the baseband circuit may modulate a signal according to one or more communication technologies. For example, a first baseband circuit and a first radio frequency circuit may modulate a signal according to a fifth generation (5G) mobile communication technology (a 5G technology for short). A second baseband circuit and a second radio frequency circuit may modulate a signal according to a fourth generation (4th generation, 4G) mobile communication technology (for example, long term evolution () or long term evolution advanced (LTE-A)) (a 4G technology for short). A third baseband circuit and a third radio frequency circuit may modulate a signal according to a wireless fidelity (Wi-Fi) technology. A fourth baseband circuit and a fourth radio frequency circuit may modulate a signal based on a Bluetooth (BT) technology. Alternatively, the first baseband circuit and the first radio frequency circuit may modulate a signal according to both the 4G technology and the 5G technology, and the second baseband circuit and the second radio frequency circuit may modulate a signal according to the Wi-Fi technology. Certainly, in some possible implementations, one baseband circuit may alternatively correspond to a plurality of radio frequency circuits, to increase an integration level. During actual application, the radio frequency circuit may be implemented through a radio frequency integrated circuit (RFIC).

The foregoing one or more communication technologies may be understood as one or more mobile communication technologies, for example, a global system for mobile communications (GSM), a general packet radio service (GPRS), code division multiple access (CDMA), wideband code division multiple access (WCDMA), time-division code division multiple access (TD-CDMA), the 4G technology, or the 5G technology. The wireless communication technology may include a wireless local area network (WLAN) (for example, a wireless fidelity (Wi-Fi) network), Bluetooth (BT), a global navigation satellite system (GNSS), frequency modulation (FM), a near field communication (NFC) technology, an infrared (IR) technology, or the like.

For example, the processing circuit 131 may further include an application circuit, and the application circuit may include one or more processors. For example, the application circuit may include, for example, but is not limited to, a circuit of one or more single-core or multi-core processors. The processor (one or more processors) may include a combination of a general-purpose processor and a dedicated processor, for example, an application processor (AP), a modem processor, a graphics processing unit (GPU), an image signal processor (ISP), a neural-network processing unit (NPU), a video codec, or a digital signal processor (DSP). These processors may be coupled to a memory/storage or may include a memory/storage, and may be configured to execute instructions stored in the memory/storage, to enable various applications or systems to be run on the electronic device 100.

For example, the baseband circuit and the radio frequency circuit may be integrated with another component in the processing circuit 131 in an independent device; or the baseband circuit and the radio frequency circuit may be independent devices independent of the processing circuit 131. In some embodiments, one baseband circuit and one radio frequency circuit may be integrated into one independent device, and the independent device and the processing circuit 131 are separately disposed.

During specific application, the baseband circuit may include, for example, but is not limited to a core processor. The baseband circuit (with a plurality of cores or more single cores) may include one or more baseband processors or one or more types of control logic, and these processors or these types of control logic are configured to generate a baseband signal of a transmission path of the radio frequency circuit. The baseband circuit may be coupled to an application circuit interface, to generate and process a baseband signal and control an operation of the radio frequency circuit.

For example, the baseband circuit may include a third generation (3G) baseband processor, a fourth generation (4G) baseband processor, a fifth generation (5G) baseband processor, or another future baseband processor. The baseband circuit may process various radio control functions used by the radio frequency circuit to communicate with one or more wireless networks.

For example, some or all functions of the baseband processor may be included in a storage module in the memory, and may be performed by a central processing unit (CPU). The radio control functions may include but are not limited to signal modulation/demodulation, encoding/decoding, radio frequency shifting, and the like.

During actual application, the modulation/demodulation function of the baseband circuit may include a function such as fast Fourier transform (FFT), precoding, or constellation mapping/demapping. The encoding/decoding function of the baseband circuit may include a convolution function, a tail-biting convolution function, a turbo function, a Viterbi function, a low-density parity check (LDPC) encoder/decoder function, or the like. Certainly, implementations of the foregoing modulation/demodulation function and the foregoing encoding/decoding function are not limited to these examples, and another suitable function may be included in another implementation.

For example, the baseband circuit may further include one or more audio digital signal processors (DSPs). The audio DSP (one or more audio DSPs) may include an element for compression/decompression and echo cancellation, and another suitable processing element may be included in another implementation.

For example, the components in the baseband circuit may be appropriately combined in a single chip machine or a single chipset, or may be disposed on a same PCB. In addition, some or all of the components of the baseband circuit and the application circuit may be disposed on a system on chip (SoC).

With development of wireless communication technologies, the baseband circuit may support one or more wireless communication technologies. In this case, the baseband circuit may support communication with an evolved universal terrestrial radio access network (E-UTRAN) or another wireless metropolitan area network (WMAN), a wireless local area network (WLAN), a wireless personal area network (WPAN), or the like. A baseband circuit configured to support a plurality of wireless communication protocols may be referred to as a multi-mode baseband circuit.

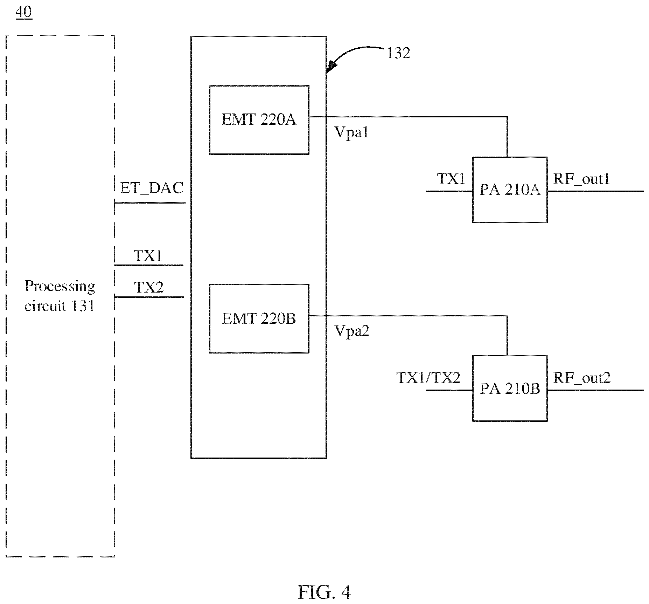

For specific application of the processing circuit 131, the power supply circuit 132, and the at least one power amplifier, refer to FIG. 4. Specifically, FIG. 4 is a schematic diagram of a structure of a wireless communication system 40 according to an embodiment of this application. The wireless communication system 40 is used in the electronic device shown in FIG. 1 to FIG. 3A and FIG. 3B, and is configured to transmit a radio frequency signal. The wireless communication system 40 includes a processing circuit 131 and a power supply circuit 132. The power supply circuit 132 includes one or more envelope tracking modulators. For example, the power supply circuit 132 shown in FIG. 4 includes an envelope tracking modulator ETM 220A and an envelope tracking modulator ETM 220B. When the wireless communication system 40 transmits a radio frequency signal, the processing circuit 131 is configured to generate a first radio frequency signal TX1 and an envelope signal of the first radio frequency signal TX1 based on data to be sent on a channel. For example, a baseband circuit in the processing circuit 131 generates a baseband signal (BS), which, for example, may be an in-phase quadrature (IQ) signal, and transmits the baseband signal to a radio frequency circuit in the processing circuit 131. The radio frequency circuit modulates the baseband signal BS to generate the first radio frequency signal TX1, where the first radio frequency signal TX1 is a radio frequency signal. The processing circuit 131 provides an envelope signal ET_DAC of the first radio frequency signal TX1 for the envelope tracking modulator ETM 220A and the envelope tracking modulator ETM 220B.

The envelope tracking modulator ETM 220A is configured to output a power supply voltage to a power supply end of a power amplifier based on the envelope signal ET_DAC.

For example, the wireless communication system 40 further includes at least one power amplifier, and the at least one power amplifier includes a power amplifier PA 210A and a power amplifier PA 210B. An output end of the envelope tracking modulator ETM 220Ais coupled to a power supply end of the power amplifier PA 210A, and the envelope tracking modulator ETM 220A is specifically configured to transmit the power supply voltage to the power supply end of the power amplifier PA 210A based on the envelope signal ET_DAC. When the first radio frequency signal TX1 meets a bandwidth range A (for example, the first radio frequency signal TX1 meets a bandwidth range in a frequency band in a 4G technology), the power amplifier PA 210A is configured to amplify output power of the first radio frequency signal TX1 based on a power supply voltage Vpa1 output by the envelope tracking modulator ETM 220A, and output a first amplified output signal RF_out1.

An output end of the envelope tracking modulator ETM 220B is coupled to a power supply end of the power amplifier PA210B, and the envelope tracking modulator ETM 220B is configured to transmit the power supply voltage to the power supply end of the power amplifier PA 210B based on the envelope signal ET_DAC. When the first radio frequency signal TX1 meets a bandwidth range B (for example, the first radio frequency signal TX1 meets a bandwidth range specified in frequency bands n41, n77, n78, and n79 in a 5G technology), the power amplifier PA 210B is configured to amplify the output power of the first radio frequency signal TX1 based on a power supply voltage Vpa2 output by the envelope tracking modulator ETM 220B, and output a second amplified output signal RF_out2.

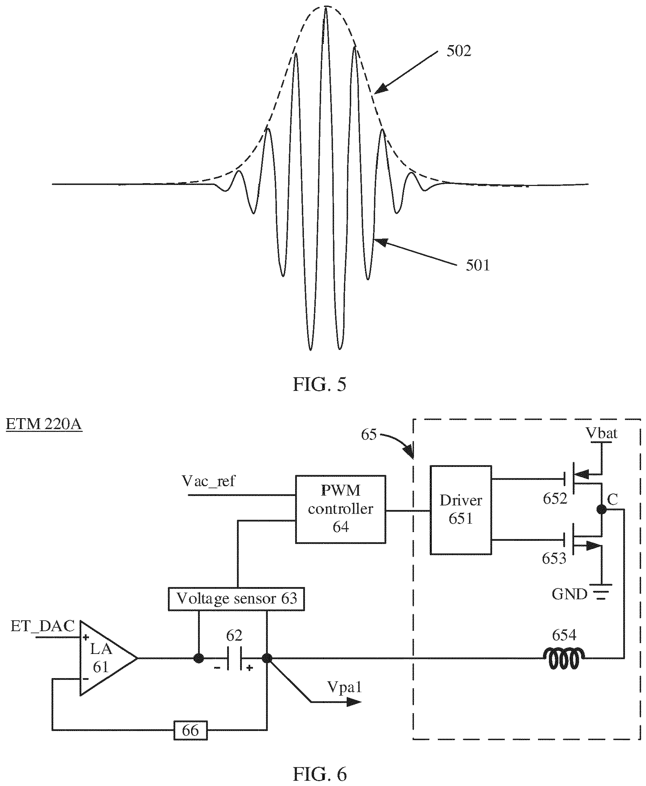

An example in which the envelope tracking modulator ETM 220A supplies power to the power amplifier PA 210A is used for description. As shown in FIG. 4 and FIG. 5, when a waveform of the first amplified output signal RF_out1 is shown by a curve 501, a waveform of the power supply voltage Vpa1 is shown by a curve 502, and the power supply voltage Vpa1 changes with an envelope of the first amplified output signal RF_out1. The envelope tracking modulator ETM 220A may dynamically adjust, based on a change of the envelope signal ET_DAC, the power supply voltage Vpa1 transmitted to the power amplifier PA 210A, so that the power amplifier PA 210A may operate in a saturation region as much as possible. In this way, transmission efficiency of the power amplifier PA 210A is improved as much as possible, to improve overall efficiency of the wireless communication system 40.

In some possible implementations, as shown in FIG. 4, because the wireless communication system 40 can support dual-channel or multi-channel transmission of a technology such as multiple-input multiple-output (MIMO), the wireless communication system 40 may provide radio frequency signals of two or more channels, that is, TX41 and TX42. When the radio frequency signals of the two channels meet different bandwidth ranges, a system indicator of the wireless communication system 40 varies greatly, and a requirement for the envelope tracking modulator also varies greatly. Therefore, for different radio frequency signals, a plurality of envelope tracking modulators need to be disposed for different bandwidth ranges. For example, as shown in FIG. 4, the envelope tracking modulator ETM 220A is correspondingly disposed for the first radio frequency signal TX1, and the envelope tracking modulator ETM 220B is correspondingly disposed for a second radio frequency signal TX2. The wireless communication system 40 needs a total of two envelope tracking modulators, to supply power to power amplifiers in different operating frequency bands in different bandwidth ranges.

Specifically, the envelope tracking modulator ETM 220A is used to describe a function of the envelope tracking modulator. Refer to FIG. 6. An embodiment of this application provides a schematic diagram of a structure of the envelope tracking modulator ETM 220A. The envelope tracking modulator ETM 220A includes a linear amplification circuit/linear amplifier (LA) 61. A positive input end of the linear amplification circuit LA 61 is coupled to an input end of the envelope tracking modulator ETM 220A, an output end of the linear amplification circuit LA 61 is coupled to a first end of a coupling capacitor 62, and a second end of the coupling capacitor 62 is coupled to the output end of the envelope tracking modulator ETM 220A. The first end of the coupling capacitor 62 is specifically a negative end of the coupling capacitor 62, and the second end of the coupling capacitor 62 is specifically a positive end of the coupling capacitor 62.

The output end of the linear amplification circuit LA 61 is coupled to a first input end of a voltage sensor 63, a second input end of the voltage sensor 63 is coupled to the output end of the envelope tracking modulator ETM 220A, an output end of the voltage sensor 63 is coupled to a first input end of a pulse width modulation (PWM) controller 64, a second input end of the PWM controller 64 is coupled to a reference voltage source, an output end of the PWM controller 64 is coupled to a control end of a buck circuit 65, and an output end of the buck circuit 65 is coupled to the output end of the envelope tracking modulator ETM 220A.

The buck circuit 65 includes a driver 651, a switch 652, a switch 653, and an inductor 654. An input end of the driver 651 is coupled to the control end of the buck circuit 65, a first output end of the driver 651 is coupled to a control end of the switch 652, a second output end of the driver 651 is coupled to a control end of the switch 653, a first end of the switch 652 is coupled to a battery voltage Vbat, a second end of the switch 652 is coupled to a first end of the switch 653, a second end of the switch 653 is coupled to the ground (GND), and the second end of the switch 652 is further coupled to the output end of the buck circuit 65 through the inductor 654.

For example, a PMIC provides the battery voltage Vbat for the envelope tracking modulator ETM 220A.

As shown in FIG. 4 and FIG. 6, the envelope tracking modulator ETM 220A receives the envelope signal ET_DAC from the input end of the envelope tracking modulator ETM 220A, and outputs the power supply voltage Vpa1 to the power amplifier PA 210A from the output end of the envelope tracking modulator ETM 220A.

Specifically, the envelope tracking modulator ETM 220A receives the envelope signal ET_DAC from the input end of the envelope tracking modulator ETM 220A. The linear amplification circuit LA 61 is configured to amplify the envelope signal ET_DAC to generate an amplified voltage Vout_la. Generally, the linear amplification circuit LA61 amplifies the envelope signal ET_DAC by 2.4 times to 2.6 times. The coupling capacitor 62 is configured to: filter out a low-frequency component and a direct current component in the amplified voltage Vout_la, generate an output voltage Vout_et1, and transmit the output voltage Vout_et1 to the output end of the envelope tracking modulator ETM 220A.

The voltage sensor 63 is configured to receive the amplified voltage Vout_la output by the linear amplification circuit LA 61. The voltage sensor 63 is further configured to receive the power supply voltage Vpa1 output by the output end of the envelope tracking modulator ETM 220A. The voltage sensor 63 is further configured to determine a difference between the amplified voltage Vout_la and the power supply voltage Vpa1, generate a bias voltage Vac_offset, and transmit the bias voltage Vac_offset to the first input end of the PWM controller 64. The reference voltage source transmits a reference voltage Vac_ref to the second input end of the PWM controller 64. The PWM controller 64 is configured to generate a buck control voltage Vdr_ct based on the bias voltage Vac_offset and the reference voltage Vac_ref, and transmit the buck control voltage Vdr_ct to the control end of the buck circuit 65. The buck circuit 65 is configured to generate an output voltage Vout_et2 based on the buck control voltage Vdr_ct, and transmit the output voltage Vout_et2 to the output end of the envelope tracking modulator ETM 220A. The output end of the envelope tracking modulator ETM 220A outputs the power supply voltage Vpa1 to the power amplifier PA 210A based on the output voltage Vout_et1 and the output voltage Vout_et2.

In the buck circuit 65, the driver 651 is configured to: generate a switch control voltage Vs based on the voltage buck control voltage Vdr_ct, transmit the switch control voltage Vs from the first output end of the driver 651 to the control end of the switch 652, and transmit the switch control voltage Vs from the second output end of the driver 651 to the control end of the switch 653. At a predetermined moment, the switch control voltage Vs generated by the driver 651 based on the buck control voltage Vdr_ct can be used to control only one of the switch 652 and the switch 653 to be turned on and the other switch to be turned off. When the switch 652 is turned on and the switch 653 is turned off, the battery voltage Vbat is coupled to the output end of the buck circuit 65 through the switch 652 and the inductor 654, to output the output voltage Vout_et2, where the output voltage Vout_et2 is a high voltage. When the switch 652 is turned off and the switch 653 is turned on, the ground (GDD) is coupled to the output end of the buck circuit 65 through the switch 653 and the inductor 654, to output the output voltage Vout_et2, where the output voltage Vout_et2 is a low voltage.

The switch 652 in FIG. 6 is specifically a P-type transistor, and the switch 653 is specifically an N-type transistor.

For example, when an amplitude of the envelope signal ET_DAC increases, the linear amplification circuit LA 61 outputs a current, the amplified voltage Vout_la output by the linear amplification circuit LA 61 increases, and the difference between the power supply voltage Vpa1 and the amplified voltage Vout_la continuously decreases, that is, the bias voltage Vac_offset output by the voltage sensor 63 continuously decreases. When the bias voltage Vac_offset is less than the reference voltage Vac_ref, the buck control voltage Vdr_ct output by the PWM controller 64 is specifically at a low level, and the switch control voltage Vs generated by the driver 651 in the buck circuit 65 based on the buck control voltage Vdr_ct at the low level is also at a low level. The switch 652 is the P-type transistor, a control end of the P-type transistor receives a low level, the P-type transistor is conducted, and the switch 652. The switch 653 is the N-type transistor, a control end of the N-type transistor receives a low level, the N-type transistor is cut off, and the switch 653 is turned off. The battery voltage Vbat is coupled to the output end of the buck circuit 65 through the switch 652 and the inductor 654, to output the output voltage Vout_et2, where the output voltage Vout_et2 is a high voltage. In this case, the power supply voltage Vpa1 increases. Finally, the difference between the power supply voltage Vpa1 and the amplified voltage Vout_la remains unchanged, that is, the bias voltage Vac_offset remains unchanged, and the linear amplification circuit LA 61 no longer outputs a current.

When an amplitude of the envelope signal ET_DAC decreases, the linear amplification circuit LA 61 absorbs a current, the amplified voltage Vout_la output by the linear amplification circuit LA 61 decreases, and the difference between the power supply voltage Vpa1 and the amplified voltage Vout_la continuously increases, that is, the bias voltage Vac_offset output by the voltage sensor 63 continuously increases. When the bias voltage Vac_offset is greater than the reference voltage Vac_ref, the buck control voltage Vdr_ct output by the PWM controller 64 is specifically at a high level, and the switch control voltage Vs generated by the driver 651 in the buck circuit 65 based on the buck control voltage Vdr_ct at the high level is also at a high level. The switch 652 is the P-type transistor, a control end of the P-type transistor receives a high level, the P-type transistor is cut off, and the switch 652. The switch 653 is the N-type transistor, a control end of the N-type transistor receives a high level, the N-type transistor is conducted, and the switch 653 is turned on. The ground (GND) is coupled to the output end of the buck circuit 65 through the switch 653 and the inductor 654, to output the output voltage Vout_et2, where the output voltage Vout_et2 is a low voltage. In this case, the power supply voltage Vpa1 decreases. Finally, the difference between the power supply voltage Vpa1 and the amplified voltage Vout_la remains unchanged, that is, the bias voltage Vac_offset remains unchanged, and the linear amplification circuit LA 61 no longer absorbs a current.

In some other embodiments, the switch 652 may alternatively be the N-type transistor, and the switch 653 may alternatively be the P-type transistor. In this case, when the bias voltage Vac_offset is less than the reference voltage Vac_ref, the buck control voltage Vdr_ct output by the PWM controller 64 outputs is specifically at a high level, and the switch control voltage Vs generated by the driver 651 in the buck circuit 65 based on the buck control voltage Vdr_ct at the high level is also at a high level, to control the switch 652 to be turned on and the switch 653 to be turned off. When the bias voltage Vac_offset is greater than the reference voltage Vac_ref, the buck control voltage Vdr_ct output by the PWM controller 64 is specifically at a low level, and the switch control voltage Vs generated by the driver 651 in the buck circuit 65 based on the buck control voltage Vdr_ct at the low level is also at a low level, to control the switch 652 to be turned off and the switch 653 to be turned on. This is not limited in this embodiment of this application.

In the foregoing example, the level of the switch control voltage Vs generated by the driver 651 is the same as the level of the buck control voltage Vdr_ct. In some other embodiments, the level of the switch control voltage Vs generated by the driver 651 may be different from the level of the buck control voltage Vdr_ct. The PWM controller 64, the driver 651, the switch 652, and the switch 653 are disposed. In this case, when the bias voltage Vac_offset is less than the reference voltage Vac_ref, the switch control voltage Vs generated by the driver 651 based on the buck control voltage Vdr_ct may be used to control the switch 652 to be turned on and the switch 653 to be turned off. When the bias voltage Vac_offset is greater than the reference voltage Vac_ref, the switch control voltage Vs generated by the driver 651 based on the buck control voltage Vdr_ct may be used to control the switch 652 to be turned off and the switch 653 to be turned on. In this way, the function of the envelope tracking modulator ETM 220A can be implemented.

For example, as shown in FIG. 6, the output end of the envelope tracking modulator ETM 220Ais further coupled to a negative input end of the linear amplification circuit LA 61 through a resistor 66, so that the envelope tracking modulator ETM 220A forms a feedback loop.

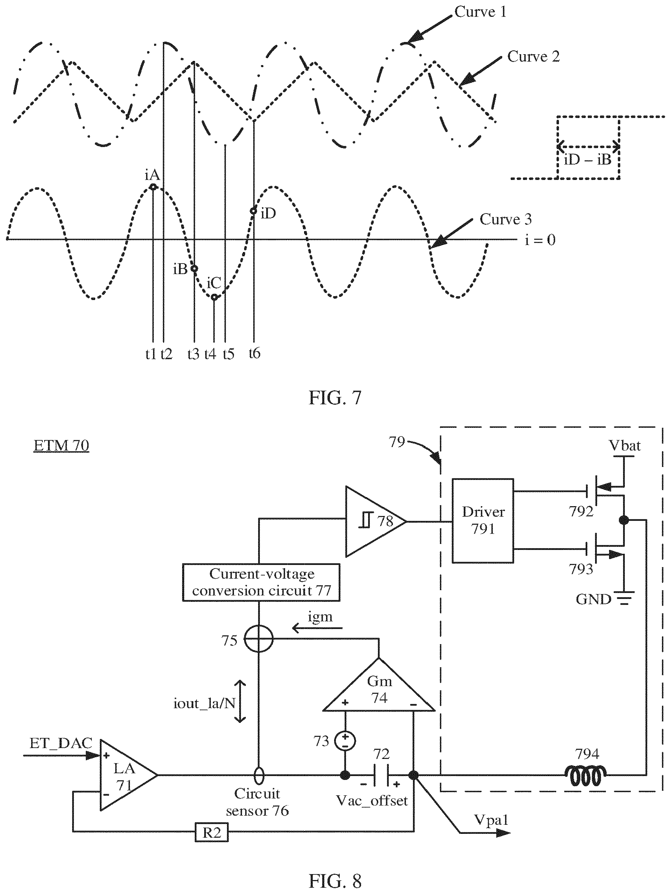

FIG. 7 shows a current change curve diagram of the envelope tracking modulator ETM 220A shown in FIG. 6. In FIG. 7, a horizontal coordinate indicates time (t), and a vertical coordinate indicates a current (i). Specifically, as shown in FIG. 7, a curve 1 shows a power supply current iout_et corresponding to the power supply voltage Vpa1 output by the envelope tracking modulator ETM 220A, a curve 2 shows an inductance current ilx transmitted by the inductor 654 in the envelope tracking modulator ETM 220A, and a curve 3 shows an amplified current iout_la corresponding to the amplified voltage Vout_la output by the linear amplification circuit LA 61 in the envelope tracking modulator ETM 220A. Refer to FIG. 7. At a moment t1, the amplitude of the envelope signal ET_DAC received by the envelope tracking modulator ETM 220A starts to decrease, and the amplified current iout_la output by the linear amplification circuit LA 61 in the envelope tracking modulator ETM 220A starts to decrease from a maximum value iA. At a moment t2 after the moment t1, the power supply current iout_et corresponding to the power supply voltage Vpa1 output by the envelope tracking modulator ETM 220A starts to decrease. At a moment t3 after the moment t2, the output voltage Vout_et2 output by the buck circuit 65 in the envelope tracking modulator ETM 220A changes to a low voltage. In this case, the inductance current ilx of the inductor 654 starts to decrease. Finally, the offset voltage Vac_offset remains unchanged, and the linear amplification circuit LA 61 no longer absorbs a current. At the moment t3, the amplified current iout_LA output by the linear amplification circuit LA 61 in the envelope tracking modulator ETM 220A is specifically iB, indicating that the output voltage Vout_et2 output by the buck circuit 65 changes to a low voltage only when the amplified current iout_la output by the linear amplification circuit LA 61 is iB.

At a moment t4, the amplitude of the envelope signal ET_DAC received by the envelope tracking modulator ETM 220A starts to increase, and the amplified current iout_la output by the linear amplification circuit LA 61 in the envelope tracking modulator ETM 220A starts to increase from a minimum value iC. At a moment t5 after the moment t4, the power supply current iout_et corresponding to the power supply voltage Vpa1 output by the envelope tracking modulator ETM 220A starts to increase. At a moment t6 after the moment t5, the output voltage Vout_et2 output by the buck circuit 65 in the envelope tracking modulator ETM 220A changes to a high voltage. In this case, the inductance current ilx of the inductor 654 starts to increase. Finally, the offset voltage Vac_offset remains unchanged, and the linear amplification circuit LA 61 no longer outputs a current. At the moment t6, the amplified current iout_LA output by the linear amplification circuit LA 61 in the envelope tracking modulator ETM 220A is specifically iD, indicating that the output voltage Vout_et2 output by the buck circuit 65 changes to a high voltage only when the amplified current iout_LA output by the linear amplification circuit LA 61 is iD.

Refer to FIG. 7. A switching window of the inductance current ilx of the inductor 654 in the envelope tracking modulator ETM 220A is iD - iB.

In the envelope tracking modulator ETM 220A shown in FIG. 6, when the envelope signal ET_DAC is a narrowband signal, a frequency of the envelope signal ET_DAC is low and changes slowly, and the envelope tracking modulator ETM 220A shown in FIG. 6 needs to take long time (for example, duration of t3 - t1 or duration of t6 - t4 in FIG. 7) to enable the linear amplification circuit LA 61 to no longer output a current or no longer absorb a current. Consequently, envelope tracking efficiency of the envelope tracking modulator ETM 220A is reduced, and operation efficiency of the power amplifier PA 210A is reduced.

To improve the envelope tracking efficiency of the envelope tracking modulator ETM 220A shown in FIG. 6, an embodiment of this application provides another envelope tracking modulator. Refer to FIG. 8. The envelope tracking modulator ETM 70 includes a linear amplification circuit LA 71. A positive input end of the linear amplification circuit LA 71 is coupled to an input end of the envelope tracking modulator ETM 70, an output end of the linear amplification circuit LA 71 is coupled to a first end of a coupling capacitor 72, and a second end of the coupling capacitor 72 is coupled to an output end of the envelope tracking modulator ETM 70. The first end of the coupling capacitor 72 is specifically a negative end of the coupling capacitor 72, and the second end of the coupling capacitor 72 is specifically a positive end of the coupling capacitor 72.

An input end of a circuit sensor 76 is coupled to a line between the output end of the linear amplification circuit LA 71 and the first end of the coupling capacitor 72, and an output end of the circuit sensor 76 is coupled to a first input end of a current adder 75.

The output end of the linear amplification circuit LA 71 is further coupled to a positive input end of a transconductance amplifier (operational transconductance amplifier, OTA, or gm amplifier, Gm) 74 through a reference voltage source 73, and a negative input end of the transconductance amplifier Gm 74 is coupled to the output end of the envelope tracking modulator ETM 70, and an output end of the transconductance amplifier Gm 74 is coupled to a second input end of the current adder 75.

An output end of the current adder 75 is coupled to an input end of a current-voltage conversion circuit 77, an output end of the current-voltage conversion circuit 77 is coupled to an input end of a hysteresis comparator (hysteresis current comparator) 78, an output end of the hysteresis comparator 78 is coupled to a control end of a buck circuit 79, and an output end of the buck circuit 79 is coupled to the output end of the envelope tracking modulator ETM 70.

The buck circuit 79 includes a driver 791, a switch 792, a switch 793, and an inductor 794. An input end of the driver 791 is coupled to the control end of the buck circuit 79, a first output end of the driver 791 is coupled to a control end of the switch 792, a second output end of the driver 791 is coupled to a control end of the switch 793, a first end of the switch 792 is coupled to a battery voltage Vbat, a second end of the switch 792 is coupled to a first end of the switch 793, a second end of the switch 793 is coupled to the ground (GND), and the second end of the switch 792 is further coupled to the output end of the buck circuit 79 through the inductor 794.

For example, a PMIC provides the battery voltage Vbat for the envelope tracking modulator ETM 70.

The envelope tracking modulator ETM 70 shown in FIG. 8 may be disposed in the wireless communication system 40 shown in FIG. 4, and the envelope tracking modulator ETM 70 replaces the envelope tracking modulator ETM 220A, and is disposed at a location of the envelope tracking modulator ETM 220A. Therefore, the envelope tracking modulator ETM 70 receives an envelope signal ET_DAC from the input end of the envelope tracking modulator ETM 70, and outputs a power supply voltage Vpa1 to a power amplifier PA 210A from the output end of the envelope tracking modulator ETM 70.

Specifically, the envelope tracking modulator ETM 70 receives the envelope signal ET_DAC from the input end of the envelope tracking modulator ETM 70. The linear amplification circuit LA 71 is configured to amplify the envelope signal ET_DAC to generate an amplified voltage Vout_la. Generally, the linear amplification circuit LA 71 amplifies the envelope signal ET_DAC by 2.4 times to 2.6 times. The coupling capacitor 72 is configured to: filter out a low-frequency component and a direct current component in the amplified voltage Vout_la, generate an output voltage Vout_et1, and transmit the output voltage Vout_et1 to the output end of the envelope tracking modulator ETM 70.

The circuit sensor 76 is configured to receive the amplified voltage Vout_la output by the linear amplification circuit LA 71, and detect the amplified voltage Vout_la to generate an induced current iout_la/N, where the induced current iout_la/N is proportional to the amplified current iout_la corresponding to the amplified voltage Vout_la, and N is a non-zero real number.

Because the negative input end of the transconductance amplifier Gm 74 is coupled to the output end of the envelope tracking modulator ETM 70, the negative input end of the transconductance amplifier Gm 74 receives the power supply voltage Vpa1 output by the envelope tracking modulator ETM 70. Because the positive input end of the transconductance amplifier Gm 74 is coupled to the output end of the linear amplification circuit LA 71 through the reference voltage source 73, where the reference voltage source 73 generates a reference voltage Vac_ref, a voltage received by the positive input end of the transconductance amplifier Gm 74 is a sum of the amplified voltage Vout_la and the reference voltage Vac_ref. The transconductance amplifier Gm 74 is configured to generate a transconductance current igm based on a sum of the amplified voltage Vout_la and the reference voltage Vac_ref and the power supply voltage Vpa1. Specifically, the transconductance amplifier Gm 74 generates the transconductance current igm, which is in direct proportion to an absolute value of the amplified voltage Vout_la + the reference voltage Vac_ref - the power supply voltage Vpa1. The reference voltage Vac_ref is a fixed value, the power supply voltage Vpa1 - the amplified voltage Vout_la is a bias voltage Vac_offset, and the amplified voltage Vout_la + the reference voltage Vac_ref - the power supply voltage Vpa41 = the reference voltage Vac_ref - the bias voltage Vac_offset. That is, the transconductance current igm is in direct proportion to the absolute value of a difference between the reference voltage Vac_ref and the bias voltage Vac_offset.

The current adder 75 is configured to generate a control current ict based on a sum of the induced current iout_la/N and the transconductance current igm. The current-voltage conversion circuit 77 is configured to generate a comparison control voltage Vhys based on the control current ict. The hysteresis comparator 78 is configured to generate a buck control voltage Vdr_ct based on the comparison control voltage Vhys, and transmit the buck control voltage Vdr_ct to the control end of the buck circuit 79. The buck circuit 79 is configured to generate an output voltage Vout_et2 based on the buck control voltage Vdr_ct, and transmit the output voltage Vout_et2 to the output end of the envelope tracking modulator ETM 70. The output end of the envelope tracking modulator ETM 70 outputs the power supply voltage Vpa1 to the power amplifier PA 210A based on the output voltage Vout_et1 and the output voltage Vout_et2.

In the buck circuit 79, the driver 791 is configured to: generate a switch control voltage Vs based on the voltage buck control voltage Vdr_ct, transmit the switch control voltage Vs from the first output end of the driver 791 to the control end of the switch 792, and transmit the switch control voltage Vs from the second output end of the driver 791 to the control end of the switch 793. At a predetermined moment, the switch control voltage Vs generated by the driver 791 based on the buck control voltage Vdr_ct can be used to control only one of the switch 792 and the switch 793 to be turned on and the other switch to be turned off. When the switch 792 is turned on and the switch 793 is turned off, the battery voltage Vbat is coupled to the output end of the buck circuit 79 through the switch 792 and the inductor 794, to output the output voltage Vout_et2, where the output voltage Vout_et2 is a high voltage. When the switch 792 is turned off and the switch 793 is turned on, the ground (GND) is coupled to the output end of the buck circuit 79 through the switch 793 and the inductor 794, to output the output voltage Vout_et2, where the output voltage Vout_et2 is a low voltage.

The switch 792 in FIG. 8 is specifically a P-type transistor, and the switch 793 is specifically an N-type transistor.

For example, when an amplitude of the envelope signal ET_DAC increases, the linear amplification circuit LA 71 outputs a current, the amplified voltage Vout_la output by the linear amplification circuit LA 71 continuously increases, a difference between the power supply voltage Vpa1 and the amplified voltage Vout_la continuously decreases, and the induced current iout_la/N output by the circuit sensor 76 is transmitted from bottom to top. When the difference between the power supply voltage Vpa1 and the amplified voltage Vout_la is less than the reference voltage Vac_ref, that is, the bias voltage Vac_offset is less than the reference voltage Vac_ref, the transconductance amplifier Gm 74 generates the transconductance current igm based on the absolute value of the difference between the bias voltage Vac_offset and the reference voltage Vac_ref, where the transconductance current igm is transmitted from bottom to top. When the induced current iout_la/N and the transconductance current igm are transmitted to the current adder 75, transmission directions of the two currents are the same, and the control current ict transmitted by the current adder 75 to the current-voltage conversion circuit 77 is greater than the induced current iout_la/N.

The current-voltage conversion circuit 77 generates the comparison control voltage Vhys based on the control current ict. The buck control voltage Vdr_ct generated by the hysteresis comparator 78 based on the comparison control voltage Vhys is specifically at a low level, and the switch control voltage Vs generated by the driver 791 in the buck circuit 79 based on the buck control voltage Vdr_ct at the low level is also at a low level. The switch 792 is the P-type transistor, a control end of the P-type transistor receives a low level, the P-type transistor is conducted, and the switch 792 is turned on. The switch 793 is the N-type transistor, a control end of the N-type transistor receives a low level, the N-type transistor is cut off, and the switch 793 is turned off. The battery voltage Vbat is coupled to the output end of the buck circuit 79 through the switch 792 and the inductor 794, to output the output voltage Vout_et2, where the output voltage Vout_et2 is a high voltage. In this case, the power supply voltage Vpa1 increases. Finally, the difference between the power supply voltage Vpa1 and the amplified voltage Vout_la remains unchanged, that is, the bias voltage Vac_offset remains unchanged, and the linear amplification circuit LA 71 no longer outputs a current.

For example, when an amplitude of the envelope signal ET_DAC decreases, the linear amplification circuit LA 71 absorbs a current, the amplified voltage Vout_la output by the linear amplification circuit LA 71 continuously decreases, a difference between the power supply voltage Vpa1 and the amplified voltage Vout_la continuously increases, and the induced current iout_la/N output by the circuit sensor 76 is transmitted from top to bottom. When the difference between the power supply voltage Vpa1 and the amplified voltage Vout_la is greater than the reference voltage Vac_ref, that is, the bias voltage Vac_offset is greater than the reference voltage Vac_ref, the transconductance amplifier Gm 74 generates the transconductance current igm based on the absolute value of the difference between the bias voltage Vac_offset and the reference voltage Vac_ref, where the transconductance current igm is transmitted from bottom to top. When the induced current iout_la/N and the transconductance current igm are transmitted to the current adder 75, transmission directions of the two currents are different, and the control current ict transmitted by the current adder 75 to the current-voltage conversion circuit 77 is less than the induced current iout_la/N.

The current-voltage conversion circuit 77 generates the comparison control voltage Vhys based on the control current ict. The buck control voltage Vdr_ct generated by the hysteresis comparator 78 based on the comparison control voltage Vhys is specifically at a high level, and the switch control voltage Vs generated by the driver 791 in the buck circuit 79 based on the buck control voltage Vdr_ct at the high level is also at a high level. The switch 792 is the P-type transistor, a control end of the P-type transistor receives a high level, the P-type transistor is cut off, and the switch 792 is turned off. The switch 793 is the N-type transistor, a control end of the N-type transistor receives a high level, the N-type transistor is cut off, and the switch 793 is turned on. The ground (GND) is coupled to the output end of the buck circuit 79 through the switch 793 and the inductor 794, to output the output voltage Vout_et2, where the output voltage Vout_et2 is a low voltage. In this case, the power supply voltage Vpa1 decreases. Finally, the difference between the power supply voltage Vpa1 and the amplified voltage Vout_la remains unchanged, that is, the bias voltage Vac_offset remains unchanged, and the linear amplification circuit LA 71 no longer absorbs a current.

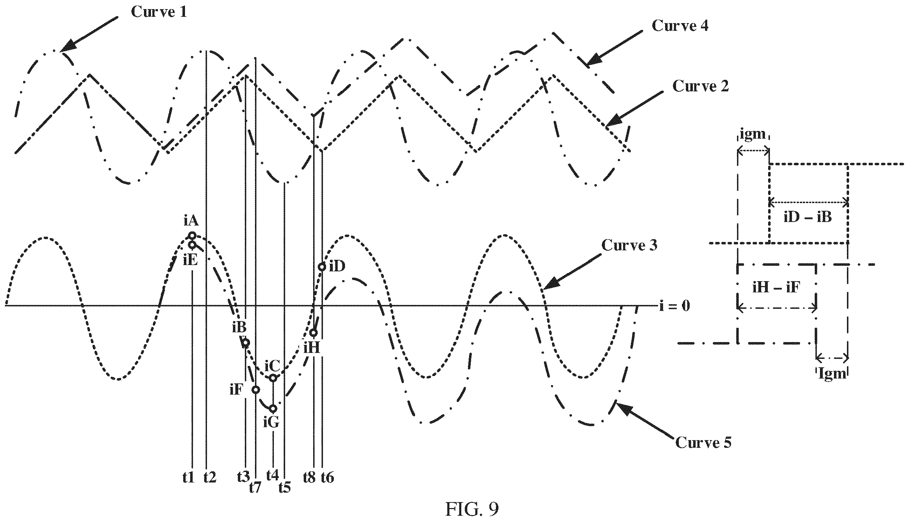

FIG. 9 shows a current change curve diagram of the envelope tracking modulator ETM 220A shown in FIG. 6 and the envelope tracking modulator ETM 70 shown in FIG. 8. In FIG. 9, a horizontal coordinate indicates time (t), and a vertical coordinate indicates a current (i). As shown in FIG. 9, a curve 1 shows a power supply current iout_et corresponding to the power supply voltage Vpa1 output by the envelope tracking modulator ETM 220A (or the envelope tracking modulator ETM 70), a curve 2 shows an inductance current ilx transmitted by the inductor 654 in the envelope tracking modulator ETM 220A, a curve 3 shows an amplified current iout_la corresponding to the amplified voltage Vout_la output by the linear amplification circuit LA 61 in the envelope tracking modulator ETM 220A, a curve 4 shows an inductance current ilx transmitted by the inductor 794 in the envelope tracking modulator ETM 70, and a curve 5 shows an amplified current iout_la corresponding to the amplified voltage Vout_la output by the linear amplification circuit LA 71 in the envelope tracking modulator ETM 70. Refer to FIG. 9. At a moment t1, the amplitude of the envelope signal ET_DAC received by the envelope tracking modulator ETM 70 decreases, and the amplified current iout_la output by the linear amplification circuit LA 71 in the envelope tracking modulator ETM 70 starts to decrease from a maximum value iE. At a moment t2 after the moment t1, the power supply current iout_et corresponding to the power supply voltage Vpa1 output by the envelope tracking modulator ETM 70 starts to decrease. At a moment t7 after the moment t3 and before a moment t4, the output voltage Vout_et2 output by the buck circuit 79 in the envelope tracking modulator ETM 70 is a low voltage. In this case, the inductance current ilx of the inductor 794 starts to decrease. Finally, the offset voltage Vac_offset remains unchanged, and the linear amplification circuit LA 71 no longer absorbs a current. At the moment t7, the amplified current iout_la output by the linear amplification circuit LA 71 in the envelope tracking modulator ETM 70 is specifically iF, indicating that the output voltage Vout_et2 output by the buck circuit 79 changes to a low voltage only when the amplified current iout_la output by the linear amplification circuit LA 71 is iF.

At the moment t4, the amplitude of the envelope signal ET_DAC received by the envelope tracking modulator ETM 70 increases, and the amplified current iout_la output by the linear amplification circuit LA 71 in the envelope tracking modulator ETM 70 starts to increase from a minimum value iG. At a moment t5 after the moment t4, the power supply current iout_et corresponding to the power supply voltage Vpa1 output by the envelope tracking modulator ETM 70 starts to increase. At a moment t8 after the moment t5 and before a moment t6, the output voltage Vout_et2 output by the buck circuit 79 in the envelope tracking modulator ETM 70 is a high voltage. In this case, the inductance current ilx of the inductor 794 starts to increase. Finally, the offset voltage Vac_offset remains unchanged, and the linear amplification circuit LA 71 no longer outputs a current. At the moment t8, the amplified current iout_la output by the linear amplification circuit LA 71 in the envelope tracking modulator ETM 70 is specifically iH, indicating that the output voltage Vout_et2 output by the buck circuit 65 changes to a low voltage only when the amplified current iout_LA output by the linear amplification circuit LA 71 is iH.

As shown in FIG. 9, a switching window of the inductance current ilx of the inductor 794 in the envelope tracking modulator ETM 70 is iH - iF. Compared with the switching window of the inductance current ilx of the inductor 654, the switching window of the inductance current ilx of the inductor 794 is translated leftwards only by a value of the transconductance current igm.

A reason why the moment t7 is after the moment t3 is as follows: When the amplitude of the envelope signal ET_DAC received by the envelope tracking modulator ETM 70 decreases, the amplified current iout_la output by the linear amplification circuit LA 71 gradually decreases, and transmission directions of the transconductance current igm generated by the transconductance amplifier Gm 74 and the amplified current iout_la are opposite. In this case, only when the amplified current iout_la continuously decreases for predetermined duration and a value decreases to iF, the inductance current ilx of the inductor 794 can be controlled to switch from gradually increasing to gradually decreasing. A reason why the moment t8 is before the moment t6 is as follows: When the amplitude of the envelope signal ET_DAC received by the envelope tracking modulator ETM 70 increases, the amplified current iout_la output by the linear amplification circuit LA 71 gradually increases, and transmission directions of the transconductance current igm generated by the transconductance amplifier Gm 74 and the amplified current iout_LA are the same. In this case, when the amplified current iout_LA is advanced for predetermined duration and a value increases to iH, the inductance current i I x of the inductor 794 can be controlled to switch from gradually decreasing to gradually increasing.

In conclusion, in the envelope tracking modulator 70 shown in FIG. 8, the transmission direction of the transconductance current igm is fixed, and the transconductance current igm cannot change with the amplitude of the envelope signal ET_DAC. Especially when the amplitude of the envelope signal ET_DAC decreases, the existence of the transconductance current igm requires the linear amplification circuit LA 71 to absorb a higher current. Consequently, envelope tracking efficiency of the envelope tracking modulator 70 is reduced.

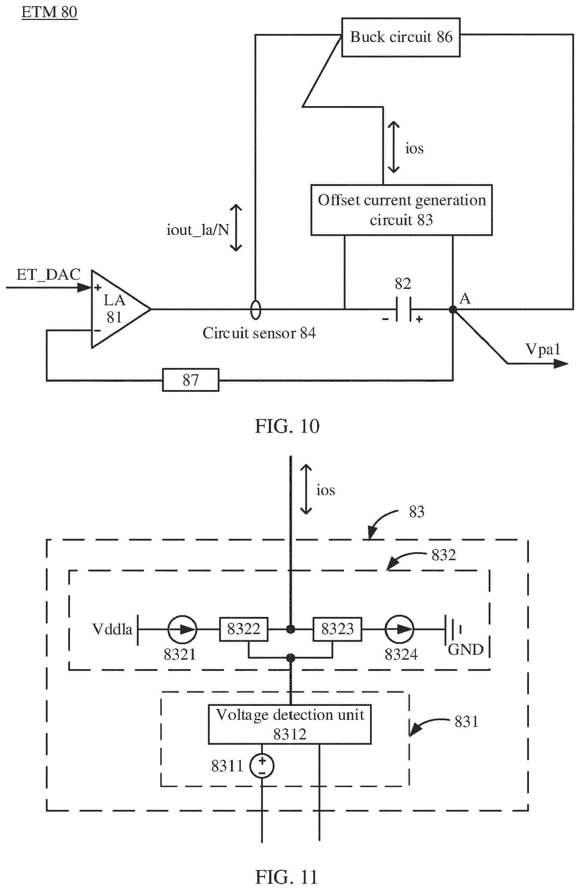

Therefore, an embodiment of this application provides an envelope tracking modulator. Envelope tracking efficiency of the envelope tracking modulator is high. When the envelope tracking modulator provides a power supply voltage for a power amplifier, operation efficiency of the power amplifier can be improved. Refer to FIG. 10. The envelope tracking modulator ETM 80 includes a linear amplification circuit LA 81, a coupling capacitor 82, a buck circuit 86, a circuit sensor 84, and an offset current generation circuit 83. An output end of the linear amplification circuit LA 81 is coupled to a first end of the coupling capacitor 82. A second end of the coupling capacitor 82 is coupled to a power supply node A. The first end of the coupling capacitor 82 is specifically a negative end of the coupling capacitor 82, and the second end of the coupling capacitor 82 is specifically a positive end of the coupling capacitor 82.

The offset current generation circuit 83 is coupled to the first end and the second end of the coupling capacitor 82, and the offset current generation circuit 83 is coupled to a control end of the buck circuit 86. An input end of the circuit sensor 84 is coupled to a line between the output end of the linear amplification circuit LA 81 and the first end of the coupling capacitor 82, and an output end of the circuit sensor 84 is coupled to the control end of the buck circuit 86. An output end of the buck circuit 86 is coupled to the power supply node A.

The envelope tracking modulator ETM 80 shown in FIG. 10 may be disposed in the wireless communication system 40 shown in FIG. 4, and the envelope tracking modulator ETM 80 replaces the envelope tracking modulator ETM 220A, and is disposed at a location of the envelope tracking modulator ETM 220A. Therefore, the envelope tracking modulator ETM 80 receives an envelope signal ET_DAC, and outputs a power supply voltage Vpa1 to a power amplifier PA 210A from the power supply node A of the envelope tracking modulator ETM 80. The power supply node A of the envelope tracking modulator ETM 80 is also referred to as an output end of the envelope tracking modulator ETM 80.

The offset current generation circuit 83 is configured to generate an offset current ios based on an amplified voltage Vout_la output by the linear amplification circuit LA 81 and the power supply voltage Vpa1 output by the power supply node A, and transmit the offset current ios to the control end of the buck circuit 86. For example, when an amplitude of the envelope signal ET_DAC increases, the linear amplification circuit LA 81 outputs a current, the amplified voltage Vout_la output by the linear amplification circuit LA 81 continuously increases, and a difference between the power supply voltage Vpa1 and the amplified voltage Vout_la continuously decreases. When the difference between the power supply voltage Vpa1 and the amplified voltage Vout_la is less than a reference voltage Vac_ref, the offset current ios generated by the offset current generation circuit 83 is transmitted from bottom to top. When an amplitude of the envelope signal ET_DAC decreases, the linear amplification circuit LA 81 absorbs a current, the amplified voltage Vout_la output by the linear amplification circuit LA 81 continuously decreases, and a difference between the power supply voltage Vpa1 and the amplified voltage Vout_la continuously increases. When the difference between the power supply voltage Vpa1 and the amplified voltage Vout_la is greater than a reference voltage Vac_ref, the offset current ios generated by the offset current generation circuit 83 is transmitted from top to bottom.

The buck circuit 86 is configured to generate an output voltage Vout_et2 based on a sum of the offset current ios and an induced current iout_la/N output by the circuit sensor 84, and transmit the output voltage Vout_et2 to the power supply node A.

For example, when the amplitude of the envelope signal ET_DAC increases, the linear amplification circuit LA 81 outputs a current, the amplified voltage Vout_la output by the linear amplification circuit LA 81 continuously increases, and the difference between the power supply voltage Vpa1 and the amplified voltage Vout_la continuously decreases. Because the linear amplification circuit LA 81 outputs a current, the induced current iout_la/N output by the circuit sensor 84 is transmitted from bottom to top. When the difference between the power supply voltage Vpa1 and the amplified voltage Vout_la is less than the reference voltage Vac_ref, the offset current ios generated by the offset current generation circuit 83 is transmitted from bottom to top, transmission directions of the induced current iout_la/N and the offset current ios are the same, and the sum of the offset current ios and the induced current iout_la/N is greater than the induced current iout_la/N.

If no offset current generation circuit 83 exists, the induced current iout_la/N is transmitted to the control end of the buck circuit 86. The buck circuit 86 generates the output voltage Vout_et2 based on the induced current iout_la/N, and a value of the induced current iout_la/N needs to be greater than a first value. In this case, the output voltage Vout_et2 generated by the buck circuit 86 based on the induced current iout_la/N is a high voltage. The power supply voltage Vpa1 increases only when the output voltage Vout_et2 is the high voltage. Finally, the difference between the power supply voltage Vpa1 and the amplified voltage Vout_la remains unchanged, and the linear amplification circuit LA 81 no longer outputs a current.

When the offset current generation circuit 83 exists, the buck circuit 86 generates the output voltage Vout_et2 based on the sum of the offset current ios and the induced current iout_la/N. When a value of the induced current iout_la/N is greater than a first value minus the offset current ios, the sum of the offset current ios and the induced current iout_la/N may be greater than the first value, and the output voltage Vout_et2 generated by the buck circuit 86 based on the offset current ios and the induced current iout_la/N is a high voltage. In this case, the power supply voltage Vpa1 increases when the output voltage Vout_et2 is the high voltage. Finally, the difference between the power supply voltage Vpa1 and the amplified voltage Vout_la remains unchanged, and the linear amplification circuit LA 81 no longer outputs a current.

It can be learned that, the existence of the offset current generation circuit 83 may enable the output voltage Vout_et2 generated by the buck circuit 86 to become the high voltage as soon as possible, so that the difference between the power supply voltage Vpa1 and the amplified voltage Vout_la remains unchanged as soon as possible, to improve envelope tracking efficiency of the envelope tracking modulator ETM 80.

When the amplitude of the envelope signal ET_DAC decreases, the linear amplification circuit LA 81 absorbs a current, the amplified voltage Vout_la output by the linear amplification circuit LA 81 continuously decreases, and the difference between the power supply voltage Vpa1 and the amplified voltage Vout_la continuously increases. Because the linear amplification circuit LA 81 absorbs a current, the induced current iout_la/N output by the circuit sensor 84 is transmitted from top to bottom. When the difference between the power supply voltage Vpa1 and the amplified voltage Vout_la is greater than the reference voltage Vac_ref, the offset current ios generated by the offset current generation circuit 83 is transmitted from top to bottom, transmission directions of the induced current iout_la/N and the offset current ios are the same, and the sum of the offset current ios and the induced current iout_la/N is less than the induced current iout_la/N.

If no offset current generation circuit 83 exists, the induced current iout_la/N is transmitted to the control end of the buck circuit 86. The buck circuit 86 generates the output voltage Vout_et2 based on the induced current iout_la/N, and a value of the induced current iout_la/N needs to be less than a second value. In this case, the output voltage Vout_et2 generated by the buck circuit 86 based on the induced current iout_la/N is a low voltage. The power supply voltage Vpa1 decreases only when the output voltage Vout_et2 is the low voltage. Finally, the difference between the power supply voltage Vpa1 and the amplified voltage Vout_la remains unchanged, and the linear amplification circuit LA 81 no longer absorbs a current.

When the offset current generation circuit 83 exists, the buck circuit 86 generates the output voltage Vout_et2 based on the sum of the offset current ios and the induced current iout_la/N. When a value of the induced current iout_la/N is less than a first value minus a current value of the offset current ios, the sum of the offset current ios and the induced current iout_la/N may be less than the second value, and the output voltage Vout_et2 generated by the buck circuit 86 based on the sum of the offset current ios and the induced current iout_la/N is a low voltage. In this case, the power supply voltage Vpa1 decreases when the output voltage Vout_et2 is the low voltage. Finally, the difference between the power supply voltage Vpa1 and the amplified voltage Vout_la remains unchanged, and the linear amplification circuit LA 81 no longer absorbs a current.

It can be learned that, the existence of the offset current generation circuit 83 may enable the output voltage Vout_et2 generated by the buck circuit 86 to become the low voltage as soon as possible, so that the difference between the power supply voltage Vpa1 and the amplified voltage Vout_la remains unchanged as soon as possible, to improve envelope tracking efficiency of the envelope tracking modulator ETM 80.

For example, in the envelope tracking modulator ETM 80 shown in FIG. 10, the envelope tracking modulator ETM 80 receives the envelope signal ET_DAC from an input end of the envelope tracking modulator ETM 80. A positive input end of the linear amplification circuit LA 81 is coupled to the input end of the envelope tracking modulator ETM 80. The linear amplification circuit LA 81 is configured to amplify the envelope signal ET_DAC received by the input end of the envelope tracking modulator ETM 80, to generate the amplified voltage Vout_la. Generally, the linear amplification circuit LA 81 amplifies the envelope signal ET_DAC by 2.4 times to 2.6 times.

The coupling capacitor 82 is configured to: filter out a low-frequency component and a direct current component in the amplified voltage Vout_la, generate an output voltage Vout_et1, and transmit the output voltage Vout_et1 to the output end of the envelope tracking modulator ETM 80.

The circuit sensor 84 is configured to detect the amplified voltage Vout_la to generate the induced current iout_la/N and output the induced current iout_la/N. For example, the circuit sensor 84 can implement current detection. The input end of the circuit sensor 84 is coupled to the line between the output end of the linear amplification circuit LA 81 and the first end of the coupling capacitor 82, or the input end of the circuit sensor 84 is coupled to the line between the output end of the linear amplification circuit LA 81 and the first end of the coupling capacitor 82 through another component. The circuit sensor 84 detects the amplified voltage Vout_la, to generate the induced current iout_la/N, where the induced current iout_la/N is proportional to the amplified current iout_la corresponding to the amplified voltage Vout_la, and N is a non-zero real number.

For example, when the amplitude of the envelope signal ET_DAC increases, the linear amplification circuit LA 81 outputs a current, and the amplified voltage Vout_la output by the linear amplification circuit LA 81 continuously increases. Because the linear amplification circuit LA 81 outputs a current, the induced current iout_la/N generated by the circuit sensor 84 by detecting the amplified voltage Vout_la is transmitted from bottom to top.

For example, when the amplitude of the envelope signal ET_DAC decreases, the linear amplification circuit LA 81 absorbs a current, and the amplified voltage Vout_la output by the linear amplification circuit LA 81 continuously decreases. Because the linear amplification circuit LA 81 absorbs a current, the induced current iout_la/N generated by the circuit sensor 84 by detecting the amplified voltage Vout_la is transmitted from top to bottom.

The circuit sensor 84 transmits the induced current iout_la/N to the control end of the buck circuit 86.

The power supply node A is configured to output the power supply voltage Vpa1 based on the output voltage Vout_et1 and the output voltage Vout_et2.

The difference between the power supply voltage Vpa1 and the amplified voltage Vout_la is also referred to as a bias voltage Vac_offset.

For example, as shown in FIG. 10, the power supply node A is further coupled to a negative input end of the linear amplification circuit LA 81 through a resistor 87, so that the envelope tracking modulator ETM 80 forms a feedback loop.

In the envelope tracking modulator ETM 80 shown in FIG. 10, specifically, a first input end of the offset current generation circuit 83 is coupled to the first end of the coupling capacitor 82, a second input end of the offset current generation circuit 83 is coupled to the second end of the coupling capacitor 82, and an output end of the offset current generation circuit 83 is coupled to the control end of the buck circuit 86.

In some embodiments, as shown in FIG. 11, the offset current generation circuit 83 includes a voltage detector 831 and an offset current generator 832. A positive input end of the voltage detector 831 is coupled to the first input end of the offset current generation circuit 83, a negative input end of the voltage detector 831 is coupled to the second input end of the offset current generation circuit 83, an output end of the voltage detector 831 is coupled to an input end of the offset current generator 832, and an output end of the offset current generator 832 is coupled to the output end of the offset current generation circuit 83.

The voltage detector 831 is configured to determine a result of comparing the difference between the power supply voltage Vpa1 and the amplified voltage Vout_la with the reference voltage Vac_ref, and generate an offset control voltage Vduty_ac based on the comparison result. The offset current generator 832 is configured to generate the offset current ios based on the offset control voltage Vduty_ac.

For example, the voltage detector 831 includes a reference voltage source 8311 and a voltage detection unit 8312. A positive input end of the voltage detection unit 8312 is coupled to the positive input end of the voltage detector 831 through the reference voltage source 8311, a negative input end of the voltage detection unit 8312 is coupled to the negative input end of the voltage detector 831, and an output end of the voltage detection unit 8312 is coupled to the output end of the voltage detector 831.

For example, the positive input end of the voltage detection unit 8312 is coupled to the positive input end of the voltage detector 831 through the reference voltage source 8311, the reference voltage source 8311 is configured to generate the reference voltage Vac_ref, the positive input end of the voltage detector 831 is coupled to the first input end of the offset current generation circuit 83, the first input end of the offset current generation circuit 83 is coupled to the first end of the coupling capacitor 82, and the output end of the linear amplification circuit LA 81 is coupled to the first end of the coupling capacitor 82. Therefore, a voltage received by the positive input end of the voltage detection unit 8312 is a sum of the amplified voltage Vout_la and the reference voltage Vac_ref.

The negative input end of the voltage detection unit 8312 is coupled to the negative input end of the voltage detector 831, the negative input end of the voltage detector 831 is coupled to the second input end of the offset current generation circuit 83, the second input end of the offset current generation circuit 83 is coupled to the second end of the coupling capacitor 82, and the second end of the coupling capacitor 82 is coupled to the power supply node A. Therefore, a voltage received by the negative input end of the voltage detection unit 8312 is the power supply voltage Vpa1.

The voltage detection unit 8312 determines a difference between a voltage input at the positive input end of the voltage detection unit 8312 and a voltage input at the negative input end of the voltage detection unit 8312. The reference voltage Vac_ref is a fixed value, and a reference voltage Vac_ref - =(a power supply voltage Vpa41 - the amplified voltage Vout_la). For example, when the amplitude of the envelope signal ET_DAC increases, the linear amplification circuit LA 81 outputs a current, the amplified voltage Vout_la output by the linear amplification circuit LA 81 continuously increases, and the difference between the power supply voltage Vpa1 and the amplified voltage Vout_la continuously decreases. When the difference between the power supply voltage Vpa1 and the amplified voltage Vout_la is less than the reference voltage Vac_ref, a voltage detection unit 8312 determines that the reference voltage Vac_ref- (the power supply voltage Vpa41 - the amplified voltage Vout_la) is less than 0, and the offset control voltage Vduty_ac generated by a voltage detector 831 based on a determined result of comparing the difference between the power supply voltage Vpa1 and the amplified voltage Vout_la with the reference voltage Vac_ref is specifically at a first level. For example, when the amplitude of the envelope signal ET_DAC decreases, the linear amplification circuit LA 81 absorbs a current, the amplified voltage Vout_la output by the linear amplification circuit LA 81 continuously decreases, and the difference between the power supply voltage Vpa1 and the amplified voltage Vout_la continuously increases. When the difference between the power supply voltage Vpa1 and the amplified voltage Vout_la is greater than the reference voltage Vac_ref, the voltage detection unit 8312 determines that the reference voltage Vac_ref- (the power supply voltage Vpa41 - the amplified voltage Vout_la) is greater than 0, and the offset control voltage Vduty_ac generated by a voltage detector 831 based on a determined result of comparing the difference between the power supply voltage Vpa1 and the amplified voltage Vout_la with the reference voltage Vac_ref is specifically at a second level.

Specifically, as shown in FIG. 11, the offset current generator 832 includes a current source 8321, a switch 8322, a switch 8323, and a current source 8324. An input end of the current source 8321 is coupled to a power supply voltage Vddla, an output end of the current source 8321 is coupled to a first end of the switch 8322, and a second end of the switch 8322 is coupled to the output end of the offset current generator 832. The second end of the switch 8322 is further coupled to a first end of the switch 8323, a second end of the switch 8323 is coupled to an input end of the current source 8324, and an output end of the current source 8324 is coupled to the ground (GND). A control end of the switch 8322 is coupled to the input end of the offset current generator 832, and a control end of the switch 8323 is coupled to the input end of the offset current generator 832. The power supply Vddla may be specifically a power supply voltage of the linear amplification circuit LA 81.

For example, when the difference between the power supply voltage Vpa1 and the amplified voltage Vout_la is less than the reference voltage Vac_ref, the offset control voltage Vduty_ac generated by the voltage detector 831 based on the determined result of comparing the difference between the power supply voltage Vpa1 and the amplified voltage Vout_la with the reference voltage Vac_ref is specifically at the first level. If the offset control voltage Vduty_ac received by the control end of the switch 8322 is at the first level, the switch 8322 is turned on, and the switch 8322 connects the current source 8321 and the output end of the offset current generator 832. If the offset control voltage Vduty_ac received by the control end of the switch 8323 is at the first level, the switch 8323 is turned off, the switch 8323 disconnects the current source 8324 from the output end of the offset current generator 832, and the current source 8321 outputs the offset current ios. Refer to FIG. 11. The offset current ios output by the current source 8321 is transmitted from left to right. After the offset current ios is output from the output end of the offset current generation circuit 83, the offset current ios is specifically transmitted from bottom to top. A transmission direction of the offset current ios is the same as a transmission direction of the induced current iout_la/N, so that a control current ict is greater than the induced current iout_la/N.

For example, when the difference between the power supply voltage Vpa1 and the amplified voltage Vout_la is greater than the reference voltage Vac_ref, the offset control voltage Vduty_ac generated by the voltage detection circuit 831 based on the determined result of comparing the difference between the power supply voltage Vpa1 and the amplified voltage Vout_la with the reference voltage Vac_ref is specifically at the second level. If the offset control voltage Vduty_ac received by the control end of the switch 8322 is at the second level, the switch 8322 is turned off, and the switch 8322 disconnects the current source 8321 from the output end of the offset current generator 832. If the offset control voltage Vduty_ac received by the control end of the switch 8323 is at the second level, the switch 8323 is turned on, the switch 8323 connects the current source 8324 and the output end of the offset current generator 832, and the current source 8324 outputs the offset current ios. Refer to FIG. 11. The offset current ios output by the current source 8324 is transmitted from left to right. After the offset current ios is output from the output end of the offset current generation circuit 83, the offset current ios is specifically transmitted from top to bottom. A transmission direction of the offset current ios is the same as a transmission direction of the induced current iout_la/N, so that a control current ict is less than the induced current iout_la/N.

For example, when the switch 8322 is a P-type transistor, and the switch 8323 is an N-type transistor, the first level is a low level, and the second level is a high level. Alternatively, when the switch 8322 is an N-type transistor, and the switch 8323 is a P-type transistor, the first level is a high level, and the second level is a low level.

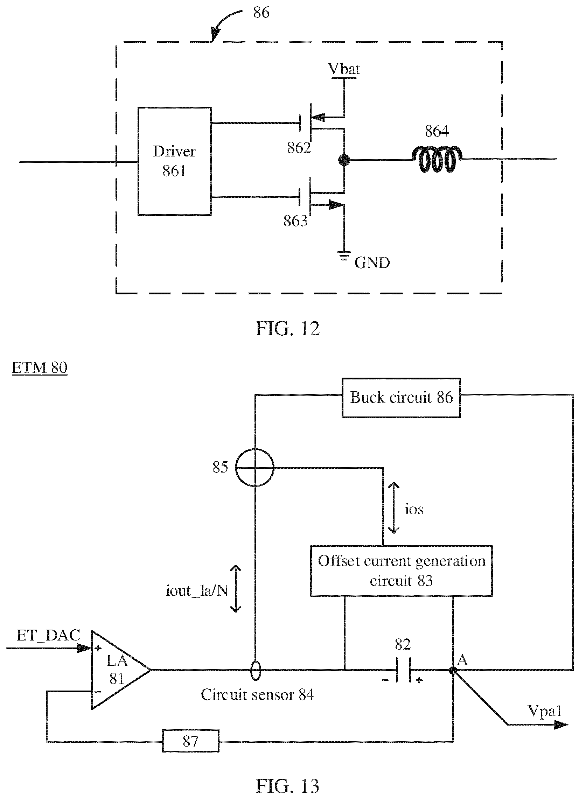

For example, as shown in FIG. 12, an embodiment of this application provides a schematic diagram of a structure of the buck circuit 86. The buck circuit 86 includes a driver 861, a switch 862, a switch 863, and an inductor 864. An input end of the driver 861 is coupled to the control end of the buck circuit 86, a first output end of the driver 861 is coupled to a control end of the switch 862, a second output end of the driver 861 is coupled to a control end of the switch 863, a first end of the switch 862 is coupled to a battery voltage Vbat, a second end of the switch 862 is coupled to a first end of the switch 863, a second end of the switch 863 is coupled to the ground (GND), and the second end of the switch 862 is further coupled to the output end of the buck circuit 86 through the inductor 864.

For example, a PMIC provides the battery voltage Vbat for the envelope tracking modulator ETM 80.

When the amplitude of the envelope signal ET_DAC increases, the linear amplification circuit LA 81 outputs a current, the amplified voltage Vout_la output by the linear amplification circuit LA 81 continuously increases, and the difference between the power supply voltage Vpa1 and the amplified voltage Vout_la continuously decreases. When the difference between the power supply voltage Vpa1 and the amplified voltage Vout_la is less than the reference voltage Vac_ref, the buck circuit 86 generates the output voltage Vout_et2 based on the control current ict. When the control current ict is greater than the first value, that is, when the induced current iout_la/N is greater than the first value minus the current value of the offset current ios, a switch control voltage Vs generated by the driver 861 based on the sum of the offset current ios and the induced current is specifically at the first level. If the switch control voltage Vs received by the control end of the switch 862 is at the first level, the switch 862 is turned on, and the switch 862 connects the battery power supply Vbat, the inductor 864, and the output end of the buck circuit 86. If the switch control voltage Vs received by the control end of the switch 863 is at the first level, the switch 863 is turned off, and the switch 863 disconnects the ground (GND), the inductor 864, and the output end of the buck circuit 86. The output voltage Vout_et2 output by the output end of the buck circuit 86 is a high voltage. In this case, the power supply voltage Vpa1 increases. Finally, the difference between the power supply voltage Vpa1 and the amplified voltage Vout_la remains unchanged, and the linear amplification circuit LA 81 no longer outputs a current.

When the amplitude of the envelope signal ET_DAC decreases, the linear amplification circuit LA 81 absorbs a current, the amplified voltage Vout_la output by the linear amplification circuit LA 81 continuously decreases, and the difference between the power supply voltage Vpa1 and the amplified voltage Vout_la continuously increases. When the difference between the power supply voltage Vpa1 and the amplified voltage Vout_la is greater than the reference voltage Vac_ref, the buck circuit 86 generates an output voltage Vout_et2 based on the control current ict. When the control current ict is less than the second value, that is, when the induced current iout_la/N is less than the second value minus the current value of the offset current ios, a switch control voltage Vs generated by the driver 861 based on the sum of the offset current ios and the induced current is specifically at the second level. If the switch control voltage Vs received by the control end of the switch 862 is at the second level, the switch 862 is turned off, and the switch 862 disconnects the battery power supply Vbat, the inductor 864, and the output end of the buck circuit 86. If the switch control voltage Vs received by the control end of the switch 863 is at the second level, the switch 863 is turned on, and the switch 863 connects the ground (GND), the inductor 864, and the output end of the buck circuit 86. The output voltage Vout_et2 output by the output end of the buck circuit 86 is a low voltage. In this case, the power supply voltage Vpa1 decreases. Finally, the difference between the power supply voltage Vpa1 and the amplified voltage Vout_la remains unchanged, and the linear amplification circuit LA 81 no longer absorbs a current.

For example, when the switch 862 is a P-type transistor, and the switch 863 is an N-type transistor, the first level is a low level, and the second level is a high level. Alternatively, when the switch 862 is an N-type transistor, and the switch 863 is a P-type transistor, the first level is a high level, and the second level is a low level.

In some embodiments, as shown in FIG. 13, the envelope tracking modulator ETM 80 further includes a current adder 85. Refer FIG. 13. The offset current generation circuit 83 is coupled to the control end of the buck circuit 86 through the current adder 85, and the output end of the circuit sensor 84 is coupled to the control end of the buck circuit 86 through the current adder 85. Specifically, the output end of the offset current generation circuit 83 is coupled to a first input end of the current adder 85, the output end of the circuit sensor 84 is coupled to a second input end of the current adder 85, and an output end of the current adder 85 is coupled to the control end of the buck circuit 86.

The current adder 85 is configured to generate the control current ict based on an induced current iout_la/N and the offset current ios. When the difference between a power supply voltage Vpa1 and the amplified voltage Vout_la is less than the reference voltage Vac_ref, the control current ict is greater than the induced current iout_la/N. When the difference between the power supply voltage Vpa1 and the amplified voltage Vout_la is greater than the reference voltage Vac_ref, the control current ict is less than the induced current iout_la/N.

For example, when the amplitude of the envelope signal ET_DAC increases, the linear amplification circuit LA 81 outputs a current, the amplified voltage Vout_la output by the linear amplification circuit LA 81 continuously increases, and the difference between the power supply voltage Vpa1 and the amplified voltage Vout_la continuously decreases. When the difference between the power supply voltage Vpa1 and the amplified voltage Vout_la is less than the reference voltage Vac_ref, the circuit sensor 84 detects the amplified voltage Vout_la to generate the induced current iout_la/N, where the induced current iout_la/N is transmitted from bottom to top, the offset current ios generated by the offset current generation circuit 83 is transmitted from bottom to top, and transmission directions of the induced current iout_la/N received by the current adder 85 and the offset current ios are the same. Therefore, the control current ict generated by the current adder 85 is greater than the induced current iout_la/N. When the amplitude of the envelope signal ET_DAC decreases, the linear amplification circuit LA 81 absorbs a current, the amplified voltage Vout_la output by the linear amplification circuit LA 81 continuously decreases, and the difference between the power supply voltage Vpa1 and the amplified voltage Vout_la continuously increases. When the difference between the power supply voltage Vpa1 and the amplified voltage Vout_la is greater than the reference voltage Vac_ref, the circuit sensor 84 detects the amplified voltage Vout_la to generate the induced current iout_la/N, where the induced current iout_la/N is transmitted from top to bottom, the offset current ios generated by the offset current generation circuit 83 is transmitted from top to bottom, and transmission directions of the induced current iout_la/N received by the current adder 85 and the offset current ios are the same. Therefore, the control current ict generated by the current adder 85 is less than the induced current iout_la/N.

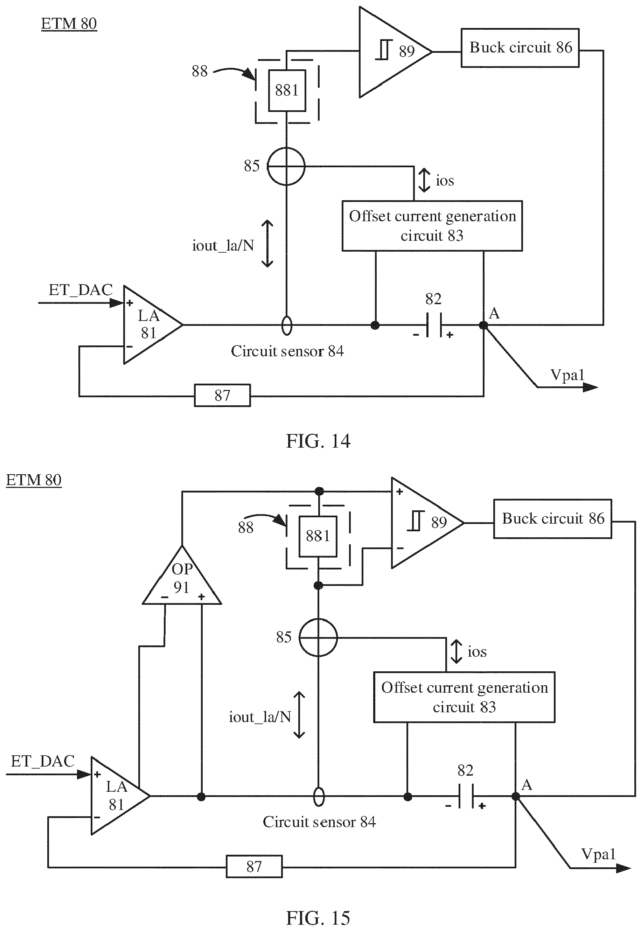

In some embodiments, as shown in FIG. 14, based on the envelope tracking modulator ETM 80 shown in FIG. 13, the envelope tracking modulator ETM 80 shown in FIG. 14 further includes a hysteresis comparator 89 disposed between the current adder 85 and the buck circuit 86, and a current-voltage conversion circuit 88 disposed between the current adder 85 and the hysteresis comparator 89.

Specifically, the output end of the current adder 85 is coupled to an input end of the current-voltage conversion circuit 88, an output end of the current-voltage conversion circuit 88 is coupled to an input end of the hysteresis comparator 89, and an output end of the hysteresis comparator 89 is coupled to the control end of the buck circuit 86.

The current-voltage conversion circuit 88 is configured to generate a comparison control voltage Vhys based on the control current ict output by the current adder 85. The hysteresis comparator 89 is configured to generate the buck control voltage Vdr_ct based on the comparison control voltage Vhys. The buck circuit 86 is specifically configured to generate the output voltage Vout_et2 based on the buck control voltage Vdr_ct.

When the amplitude of the envelope signal ET_DAC increases, the linear amplification circuit LA 81 outputs a current, the amplified voltage Vout_la output by the linear amplification circuit LA 81 continuously increases, and the difference between the power supply voltage Vpa1 and the amplified voltage Vout_la continuously decreases. When the difference between the power supply voltage Vpa1 and the amplified voltage Vout_la is less than the reference voltage Vac_ref, the control current ict is transmitted from bottom to top, and the comparison control voltage Vhys generated by the current-voltage conversion circuit 88 based on the control current ict continuously increases. When the control current ict is greater than the first value, the comparison control voltage Vhys is greater than a first threshold of the hysteresis comparator 89, and the hysteresis comparator 89 is configured to generate the buck control voltage Vdr_ct based on the comparison control voltage Vhys, where the buck control voltage Vdr_ct is at the first level. The buck control voltage Vdr_ct received by the driver 861 in the buck circuit 86 is at the first level, the switch control voltage Vs generated by the driver 861 based on the buck control voltage Vdr_ct is at the first level, the switch 862 is turned on, and the switch 863 is turned off. The output voltage Vout_et2 output by the output end of the buck circuit 86 is a high voltage. In this case, the power supply voltage Vpa1 increases. Finally, the difference between the power supply voltage Vpa1 and the amplified voltage Vout_la remains unchanged, and the linear amplification circuit LA 81 no longer outputs a current.

When the amplitude of the envelope signal ET_DAC decreases, the linear amplification circuit LA 81 absorbs a current, the amplified voltage Vout_la output by the linear amplification circuit LA 81 continuously decreases, and the difference between the power supply voltage Vpa1 and the amplified voltage Vout_la continuously increases. When the difference between the power supply voltage Vpa1 and the amplified voltage Vout_la is greater than the reference voltage Vac_ref, the control current ict is transmitted from top to bottom, and the comparison control voltage Vhys generated by the current-voltage conversion circuit 88 based on the control current ict continuously decreases. When the control current ict is less than the second value, the comparison control voltage is less than a second threshold of the hysteresis comparator 89, and the hysteresis comparator 89 is configured to generate the buck control voltage Vdr_ct based on the comparison control voltage Vhys, where the buck control voltage Vdr_ct is at the second level. The buck control voltage Vdr_ct received by the driver 861 in the buck circuit 86 is at the second level, the switch control voltage Vs generated by the driver 861 based on the buck control voltage Vdr_ct is at the second level, the switch 862 is turned off, and the switch 863 is turned on. The output voltage Vout_et2 output by the output end of the buck circuit 86 is a low voltage. In this case, the power supply voltage Vpa1 decreases. Finally, the difference between the power supply voltage Vpa1 and the amplified voltage Vout_la remains unchanged, and the linear amplification circuit LA 81 no longer absorbs a current.

For example, as shown in FIG. 14, the current-voltage conversion circuit 88 includes a resistor 881. A first end of the resistor 881 is coupled to the input end of the current-voltage conversion circuit 88, a second end of the resistor 881 is coupled to the output end of the current-voltage conversion circuit 88, a positive input end of the hysteresis comparator 89 is coupled to the output end of the current-voltage conversion circuit 88, and a negative input end of the hysteresis comparator 89 is coupled to the input end of the current-voltage conversion circuit 88.

For example, when the amplitude of the envelope signal ET_DAC increases, the linear amplification circuit LA 81 outputs a current, the amplified voltage Vout_la output by the linear amplification circuit LA 81 continuously increases, and the difference between the power supply voltage Vpa1 and the amplified voltage Vout_la continuously decreases. When the difference between the power supply voltage Vpa1 and the amplified voltage Vout_la is less than the reference voltage Vac_ref, the control current ict is transmitted from bottom to top. In this case, a voltage input at the positive input end of the hysteresis comparator 89 is greater than a voltage input at the negative input end of the hysteresis comparator, the hysteresis comparator 89 determines that a difference between the voltage input at the positive input end of the hysteresis comparator 89 and the voltage input at the negative input end of the hysteresis comparator is greater than the first threshold of the hysteresis comparator 89, and the buck control voltage Vdr_ct generated by the hysteresis comparator 89 is at the first level.

For example, when the amplitude of the envelope signal ET_DAC decreases, the linear amplification circuit LA 81 absorbs a current, the amplified voltage Vout_la output by the linear amplification circuit LA 81 continuously decreases, and the difference between the power supply voltage Vpa1 and the amplified voltage Vout_la continuously increases. When the difference between the power supply voltage Vpa1 and the amplified voltage Vout_la is greater than the reference voltage Vac_ref, the control current ict is transmitted from top to bottom. In this case, a voltage input at the positive input end of the hysteresis comparator 89 is less than a voltage input at the negative input end of the hysteresis comparator, the hysteresis comparator 89 determines that a difference between the voltage input at the positive input end of the hysteresis comparator 89 and the voltage input at the negative input end of the hysteresis comparator is less than the second threshold of the hysteresis comparator 89, and the buck control voltage Vdr_ct generated by the hysteresis comparator 89 is at the second level.

In the foregoing embodiment, the buck control voltage Vdr_ct received by the driver 861 in the buck circuit 86 is at the first level, the switch control voltage Vs generated by the driver 861 based on the buck control voltage Vdr_ct is also at the first level, the buck control voltage Vdr_ct received by the driver 861 in the buck circuit 86 is at the second level, and the switch control voltage Vs generated by the driver 861 based on the buck control voltage Vdr_ct is also at the second level. In some other embodiments, the buck control voltage Vdr_ct received by the driver 861 in the buck circuit 86 may be at the second level, the switch control voltage Vs generated by the driver 861 based on the buck control voltage Vdr_ct is at the first level, the buck control voltage Vdr_ct received by the driver 861 in the buck circuit 86 is at the first level, and the switch control voltage Vs generated by the driver 861 based on the buck control voltage Vdr_ct is at the second level. This is not limited in embodiments of this application.

For example, in some other embodiments, as shown in FIG. 15, the linear amplification circuit LA 81 further includes a mirror output end; the envelope tracking modulator ETM 80 further includes an operational amplifier OP 91; and a positive input end of the operational amplifier OP 91 is coupled to the output end of the linear amplification circuit LA 81, a negative input end of the operational amplifier OP 91 is coupled to the mirror output end of the linear amplification circuit LA 81, and an output end of the operational amplifier OP 91 is coupled to the output end of the current-voltage conversion circuit 88.

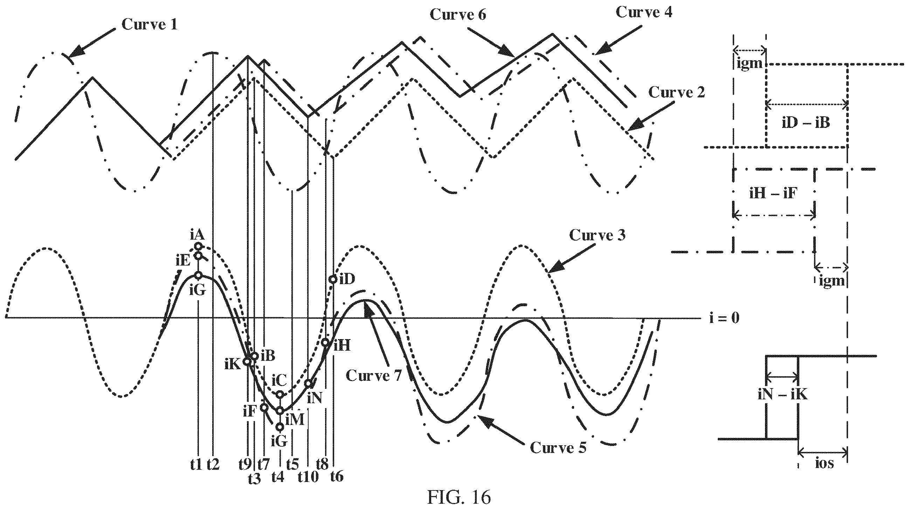

FIG. 16 shows a current change curve diagram of the envelope tracking modulator ETM 220A shown in FIG. 6, the envelope tracking modulator ETM 70 shown in FIG. 8, and the envelope tracking modulator ETM 80 shown in FIG. 10, FIG. 13, FIG. 14, or FIG. 15. In FIG. 16, a horizontal coordinate indicates time (t), and a vertical coordinate indicates a current (i). Specifically, as shown in FIG. 16, a curve 1 shows the power supply current iout_et corresponding to the power supply voltage Vpa1 output by the envelope tracking modulator ETM 220A (or the envelope tracking modulator ETM 70 or the envelope tracking modulator ETM 80), a curve 2 shows the inductance current ilx transmitted by the inductor 654 in the envelope tracking modulator ETM 220A, and a curve 3 shows the amplified current iout_la corresponding to the amplified voltage Vout_la output by the linear amplification circuit LA 61 in the envelope tracking modulator ETM 220A, a curve 4 shows the inductance current ilx transmitted by the inductor 794 in the envelope tracking modulator ETM 70, a curve 5 shows the amplified current iout_la corresponding to the amplified voltage Vout_la output by the linear amplification circuit LA 71 in the envelope tracking modulator ETM 70, a curve 6 shows the inductance current ilx transmitted by the inductor 864 in the envelope tracking modulator ETM 80, and a curve 7 shows the amplified current iout_la output by the linear amplification circuit LA 81 in the envelope tracking modulator ETM 80. As shown in FIG. 16, at a moment t1, the amplitude of the envelope signal ET_DAC received by the envelope tracking modulator ETM 80 decreases, and the amplified current iout_la output by the linear amplification circuit LA 81 in the envelope tracking modulator ETM 80 starts to decrease from a maximum value iG. At a moment t2 after the moment t1, the power supply current iout_et corresponding to the power supply voltage Vpa1 output by the envelope tracking modulator ETM 80 starts to decrease. At a moment t9 after the moment t2 and before a moment t3, the output voltage Vout_et2 output by the buck circuit 86 in the envelope tracking modulator ETM 80 is a low voltage. In this case, the inductance current ilx of the inductor 864 starts to decrease. Finally, the difference between the power supply voltage Vpa1 and the amplified voltage Vout_la remains unchanged, and the linear amplification circuit LA 81 no longer absorbs a current. At the moment t9, the amplified current iout_la output by the linear amplification circuit LA 81 in the envelope tracking modulator ETM 80 is specifically iK, indicating that the output voltage Vout_et2 output by the buck circuit 86 changes to a low voltage only when the amplified current iout_la output by the linear amplification circuit LA 81 is iK.

At a moment t4, the amplitude of the envelope signal ET_DAC received by the envelope tracking modulator ETM 80 increases, and the amplified current iout_la output by the linear amplification circuit LA 81 in the envelope tracking modulator ETM 80 starts to increase from a minimum value iM. At a moment t5 after the moment t4, the power supply current iout_et corresponding to the power supply voltage Vpa1 output by the envelope tracking modulator ETM 80 starts to increase. At a moment t10 after the moment t5 and before the moment t8, the output voltage Vout_et2 output by the buck circuit 86 in the envelope tracking modulator ETM 80 is a high voltage. In this case, the inductance current ilx of the inductor 864 starts to increase. Finally, the difference between the power supply voltage Vpa1 and the amplified voltage Vout_la remains unchanged, and the linear amplification circuit LA 81 no longer outputs a current. At the moment t10, the amplified current iout_la output by the linear amplification circuit LA 81 in the envelope tracking modulator ETM 80 is specifically iN, indicating that the output voltage Vout_et2 output by the buck circuit 86 changes to a high voltage only when the amplified current iout_la output by the linear amplification circuit LA 81 is iN.

As shown in FIG. 16, a switching window of the inductance current ilx of the inductor 864 in the envelope tracking modulator ETM 80 is iN - iK. Compared with the switching window of the inductance current ilx of the inductor 654, in switching window of the inductance current ilx of the inductor 864, a current at a left endpoint is almost unchanged, and a current at a right endpoint is translated leftwards by the value of the offset current ios.

Refer to FIG. 16. A reason why the moment t9 is before the moment t3 is as follows: When the amplified current iout_la output by the linear amplification circuit LA 81 in the envelope tracking modulator ETM 80 gradually decreases, transmission directions of the offset current ios generated by the offset current generation circuit 83 and the amplified current iout_LAare the same. In this case, when the amplified current iout_la is advanced for predetermined duration and a value is iK, the inductance current ilx of the inductor 864 can be controlled to switch from gradually increasing to gradually decreasing. A reason why the moment t10 is before the moment t8 is as follows: When the amplified current iout_la output by the linear amplification circuit LA 81 in the envelope tracking modulator ETM 80 gradually increases, transmission directions of the offset current ios generated by the offset current generation circuit 83 and the amplified current iout_la are the same. In this case, the amplified current iout_la is advanced for predetermined duration and a value is iN. In this case, the inductance current ilx of the inductor 864 can be controlled to switch from gradually decreasing to gradually increasing.

Although this application is described with reference to specific features and embodiments thereof, it is clear that various modifications and combinations may be made to them without departing from the scope of this application. Correspondingly, the specification and the accompanying drawings are merely example descriptions of this application defined by the appended claims, and are considered as any of or all modifications, variations, combinations or equivalents that cover the scope of this application. It is clear that a person skilled in the art can make various modifications and variations to this application without departing from the scope of this application. In this way, this application is intended to cover these modifications and variations of this application provided that they fall within the scope of protection of the claims of this application and their equivalent technologies.

## Claims

1. An envelope tracking modulator, comprising a linear amplification circuit, a coupling capacitor, a buck circuit, a circuit sensor, and an offset current generation circuit, wherein
an output end of the linear amplification circuit is coupled to a first end of the coupling capacitor, and a second end of the coupling capacitor is coupled to a power supply node;
the offset current generation circuit is coupled to the first end and the second end of the coupling capacitor, and the offset current generation circuit is further coupled to a control end of the buck circuit;
an input end of the circuit sensor is coupled to a line between the output end of the linear amplification circuit and the first end of the coupling capacitor, and an output end of the circuit sensor is coupled to the control end of the buck circuit;
an output end of the buck circuit is coupled to the power supply node;
the offset current generation circuit is configured to generate an offset current based on an amplified voltage output by the linear amplification circuit and a power supply voltage output by the power supply node; and
the buck circuit is configured to generate a first output voltage based on a sum of the offset current and an induced current output by the circuit sensor, wherein when a difference between the power supply voltage and the amplified voltage is less than a reference voltage, the sum of the offset current and the induced current is greater than the induced current; or when a difference between the power supply voltage and the amplified voltage is greater than a reference voltage, the sum of the offset current and the induced current is less than the induced current.

2. The envelope tracking modulator according to claim 1, wherein
a first input end of the offset current generation circuit is coupled to the first end of the coupling capacitor, a second input end of the offset current generation circuit is coupled to the second end of the coupling capacitor, and an output end of the offset current generation circuit is coupled to the control end of the buck circuit;
the offset current generation circuit comprises a voltage detector and an offset current generator;
a positive input end of the voltage detector is coupled to the first input end of the offset current generation circuit, a negative input end of the voltage detector is coupled to the second input end of the offset current generation circuit, an output end of the voltage detector is coupled to an input end of the offset current generator, and an output end of the offset current generator is coupled to the output end of the offset current generation circuit;
the voltage detector is configured to determine a result of comparing the difference between the power supply voltage and the amplified voltage with the reference voltage, and generate an offset control voltage based on the comparison result; and
the offset current generator is configured to generate the offset current based on the offset control voltage.

3. The envelope tracking modulator according to claim 2, wherein
the offset current generator comprises a first current source, a first switch, a second switch, and a second current source;
an input end of the first current source is coupled to the power supply voltage, an output end of the first current source is coupled to a first end of the first switch, and a second end of the first switch is coupled to the output end of the offset current generator;
the second end of the first switch is further coupled to a first end of the second switch, a second end of the second switch is coupled to an input end of the second current source, and an output end of the second current source is coupled to the ground; and
a control end of the first switch is coupled to the input end of the offset current generator, and a control end of the second switch is coupled to the input end of the offset current generator.

4. The envelope tracking modulator according to claim 3, wherein
when the difference between the power supply voltage and the amplified voltage is less than the reference voltage, the offset control voltage is at a first level, the first switch connects the first current source and the output end of the offset current generator, the second switch disconnects the second current source from the output end of the offset current generator, and the first current source outputs the offset current; or
when the difference between the power supply voltage and the amplified voltage is greater than the reference voltage, the offset control voltage is at a second level, the first switch disconnects the first current source from the output end of the offset current generator, the second switch connects the second current source and the output end of the offset current generator, and the second current source outputs the offset current.

5. The envelope tracking modulator according to any one of claims 1 to 4, wherein
the buck circuit comprises a driver, a third switch, a fourth switch, and an inductor; and
an input end of the driver is coupled to the control end of the buck circuit, a first output end of the driver is coupled to a control end of the third switch, a second output end of the driver is coupled to a control end of the fourth switch, a first end of the third switch is coupled to a battery voltage, a second end of the third switch is coupled to a first end of the fourth switch, a second end of the fourth switch is coupled to the ground, and the second end of the third switch is further coupled to the output end of the buck circuit through the inductor.

6. The envelope tracking modulator according to any one of claims 1 to 5, wherein
the envelope tracking modulator further comprises a current adder; and
the offset current generation circuit is coupled to the control end of the buck circuit through the current adder, and the output end of the circuit sensor is coupled to the control end of the buck circuit through the current adder.

7. The envelope tracking modulator according to claim 6, wherein
the current adder is configured to generate a control current based on the induced current and the offset current, and output the control current.

8. The envelope tracking modulator according to claim 6 or 7, wherein
the envelope tracking modulator further comprises a hysteresis comparator disposed between the current adder and the buck circuit, and a current-voltage conversion circuit disposed between the current adder and the hysteresis comparator.

9. The envelope tracking modulator according to claim 8, wherein
the current-voltage conversion circuit is configured to generate a comparison control voltage based on the control current output by the current adder;
the hysteresis comparator is configured to generate a buck control voltage based on the comparison control voltage; and
the buck circuit is specifically configured to generate a second output voltage based on the buck control voltage.

10. The envelope tracking modulator according to claim 8 or 9, wherein
the linear amplification circuit further comprises a mirror output end;
the envelope tracking modulator further comprises an operational amplifier; and
a positive input end of the operational amplifier is coupled to the output end of the linear amplification circuit, a negative input end of the operational amplifier is coupled to the mirror output end of the linear amplification circuit, and an output end of the operational amplifier is coupled to an output end of the current-voltage conversion circuit.

11. The envelope tracking modulator according to any one of claims 8 to 10, wherein
the current-voltage conversion circuit comprises a resistor, a first end of the resistor is coupled to an input end of the current-voltage conversion circuit, and a second end of the resistor is coupled to the output end of the current-voltage conversion circuit; and
a positive input end of the hysteresis comparator is coupled to the output end of the current-voltage conversion circuit, and a negative input end of the hysteresis comparator is coupled to the input end of the current-voltage conversion circuit.

12. The envelope tracking modulator according to any one of claims 1 to 11, wherein
the linear amplification circuit is configured to amplify an envelope signal received by the envelope tracking modulator, to generate the amplified voltage;
the coupling capacitor is configured to: filter out a low-frequency component and a direct current component in the amplified voltage, generate a second output voltage, and transmit the second output voltage to the power supply node;
the circuit sensor is configured to detect the amplified voltage to generate and output the induced current; and
the power supply node is configured to output the power supply voltage based on the first output voltage and the second output voltage.

13. A wireless communication system, comprising a processing circuit and a power supply circuit, wherein
the power supply circuit comprises one or more envelope tracking modulators according to any one of claims 1 to 12;
the processing circuit is configured to generate a radio frequency signal and an envelope signal of the radio frequency signal based on to-be-sent data; and
the envelope tracking modulator is configured to generate a power supply voltage of a power amplifier based on the envelope signal.

14. The wireless communication system according to claim 13, further comprising the power amplifier, wherein
the power amplifier is configured to amplify output power of the radio frequency signal based on the power supply voltage.
